# EUROPEAN PATENT APPLICATION

(11) **EP 4 742 848 A1**
(43) Date of publication of application: **13.05.2026**
(21) Application number: 25765465.7
(22) Date of filing: 12.09.2025
(51) Int. Cl.: H05K 7/20, H04M 1/02, H05K 1/02, H05K 5/00

(54) **ELECTRONIC DEVICE COMPRISING STRUCTURE FOR IMPROVING HEAT DISSIPATION PERFORMANCE**

(30) Priority: 13.09.2024 KR 20240126219; 23.10.2024 KR 20240145535
(71) Applicant: Samsung Electronics Co., Ltd., Suwon-si, Gyeonggi-do 16677 (KR)
(72) Inventor: CHUNG, Haein, Suwon-si, Gyeonggi-do 16677 (KR); KIM, Minjun, Suwon-si, Gyeonggi-do 16677 (KR); KIM, Youzip, Suwon-si, Gyeonggi-do 16677 (KR); KIM, Jihong, Suwon-si, Gyeonggi-do 16677 (KR); KIM, Taeyoung, Suwon-si, Gyeonggi-do 16677 (KR); LEE, Miji, Suwon-si, Gyeonggi-do 16677 (KR); CHOI, Myoungjun, Suwon-si, Gyeonggi-do 16677 (KR)
(74) Representative: HGF
(86) International application number: PCT/KR2025/014276
(87) International publication number: WO 2026/059388

(57) **Abstract**

According to an embodiment, a foldable electronic device includes a housing including a first housing part including a first heat-conductive plate and a second housing part including a second heat-conducive plate and an elastic member, an electronic component disposed in the housing, and a hinge assembly rotatably coupling the first housing part and the second housing part. The first heat-conductive plate may be configured to be in contact with the second heat-conductive plate in an unfolded state of the foldable electronic device such that the first and second heat-conductive plates form a heat conduction path between the first and second housing parts for heat generated from the electronic component. The elastic member may provide a repulsion force to the second heat-conductive plate toward the first heat-conductive plate in the unfolded state of the foldable electronic device such that the second heat-conductive plate is closely contacted with the first heat-conductive plate.

## Description

### [Technical Field]

The present disclosure relates to an electronic device including a structure for improving heat dissipation performance.

### [Background Art]

Electronic devices that include a large-screen display may increase user utilization. As demand for a highly portable electronic device increases, the electronic device may include a deformable display. For example, the electronic device may include a deformable display such as a foldable flexible display. The electronic device may be miniaturized by including a deformable display. As electronic components disposed in the electronic device perform an operation for responding to a request of a user, heat may be generated in the miniaturized electronic device. Therefore, the electronic device may be required to have a structure to dissipate the heat generated from the electronic components.

The above-described information may be provided as a related art for the purpose of helping to understand the present disclosure. No claim or determination is raised as to whether any of the above-described description may be applied as a prior art related to the present disclosure.

### [Disclosure]

### [Technical Solution]

A foldable electronic device is disclosed. The foldable electronic device may comprise a housing including a first housing part including a first heat-conductive plate and a second housing part including a second heat-conducive plate and an elastic member, an electronic component disposed in the housing, and a hinge assembly rotatably coupling the first housing part and the second housing part. The first heat-conductive plate may be configured to be in contact with the second heat-conductive plate in an unfolded state of the foldable electronic device such that the first and second heat-conductive plates form a heat conduction path between the first and second housing parts for heat generated from the electronic component. The elastic member may provide a repulsion force to the second heat-conductive plate toward the first heat-conductive plate in the unfolded state of the foldable electronic device such that the second heat-conductive plate is closely contacted with the first heat-conductive plate.

A foldable electronic device is disclosed. The foldable electronic device may comprise a housing including a first housing part including a first heat-conductive plate and a second housing part including a guide assembly including a second heat-conducive plate and an elastic member, an electronic component disposed in the housing, and a hinge assembly rotatably coupling the first housing part and the second housing part. The first heat-conductive plate may be configured to be in contact with the second heat-conductive plate in an unfolded state of the foldable electronic device such that the first and second heat-conductive plates form a heat conduction path between the first and second housing parts for heat generated from the electronic component. The elastic member may provide a repulsion force to the second heat-conductive plate toward the first heat-conductive plate with respect to a force exerted to the first heat-conductive plate from the second heat-conductive plate in the unfolded state of the foldable electronic device such that the second heat-conductive plate is closely contacted with the first heat-conductive plate.

A foldable electronic device is disclosed. The foldable electronic device may comprise a housing including a first housing part including a first heat-conductive plate and a second housing part, a guide assembly including a guide plate coupled to the second housing part, a second heat-conducive plate movably coupled to the guide plate, and an elastic member, coupled to the guide plate to be in contact with the second heat-conductive plate, an electronic component disposed in the housing, and a hinge assembly rotatably coupling the first housing part and the second housing part through the first heat-conductive plate and the guide assembly. The first heat-conductive plate of the second housing part may be configured to contact with the second heat-conductive plate of the first housing part in an unfolded state of the foldable electronic device such that the first and second heat-conductive plates form a heat conduction path between the first and second housing parts for heat generated from the electronic component. The elastic member may provide a repulsion force to the second heat-conductive plate toward the first heat-conductive plate with respect to a force exerted to the first heat-conductive plate from the second heat-conductive plate in the unfolded state of the foldable electronic device such that the second heat-conductive plate is closely contacted with the first heat-conductive plate.

### [Description of the Drawings]

FIG. 1 is a block diagram of an electronic device in a network environment according to various embodiments.
FIG. 2A illustrates an unfolded state of an exemplary electronic device.
FIG. 2B illustrates a folded state of an exemplary electronic device.
FIG. 2C is an exploded view of an exemplary electronic device.
FIG. 2D illustrates an unfolded state of an exemplary electronic device.
FIG. 2E illustrates a folded state of an exemplary electronic device.
FIG. 3A illustrates a portion of an exemplary electronic device in a folded state.
FIG. 3B illustrates a portion of an exemplary electronic device in an unfolded state.
FIG. 4 illustrates a portion of an exemplary electronic device in an unfolded state.
FIG. 5A is a top plan view of a first plate of an exemplary electronic device.
FIG. 5B is a bottom view of a first plate of an exemplary electronic device.
FIG. 5C is an exploded perspective view of a guide assembly of an exemplary electronic device.
FIGS. 5D and 5E are perspective views of a first plate and a guide assembly of an exemplary electronic device in contact with each other.
FIG. 6A is a side view of a first plate and a guide assembly of an exemplary electronic device.
FIG. 6B illustrates a portion of a second heat conduction member of an exemplary electronic device.

### [Mode for Invention]

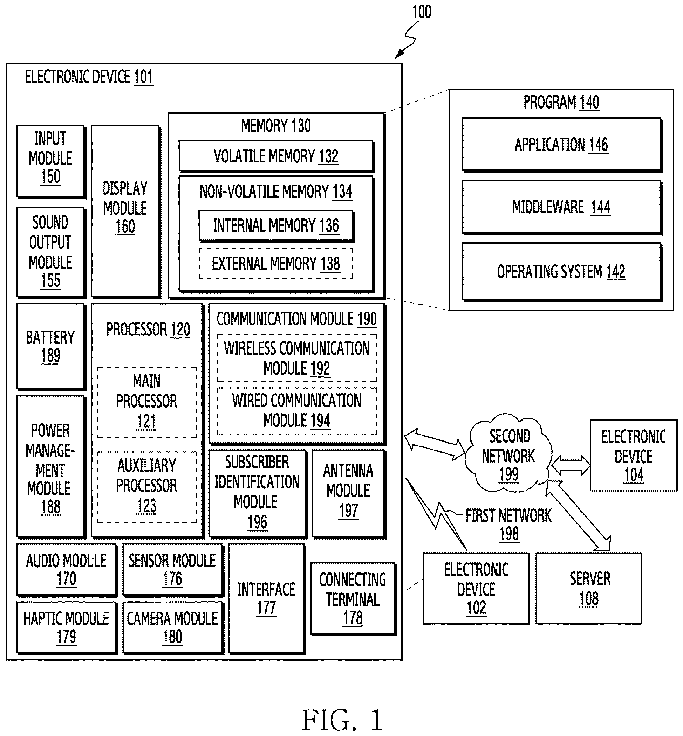

FIG. 1 is a block diagram of an electronic device in a network environment according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

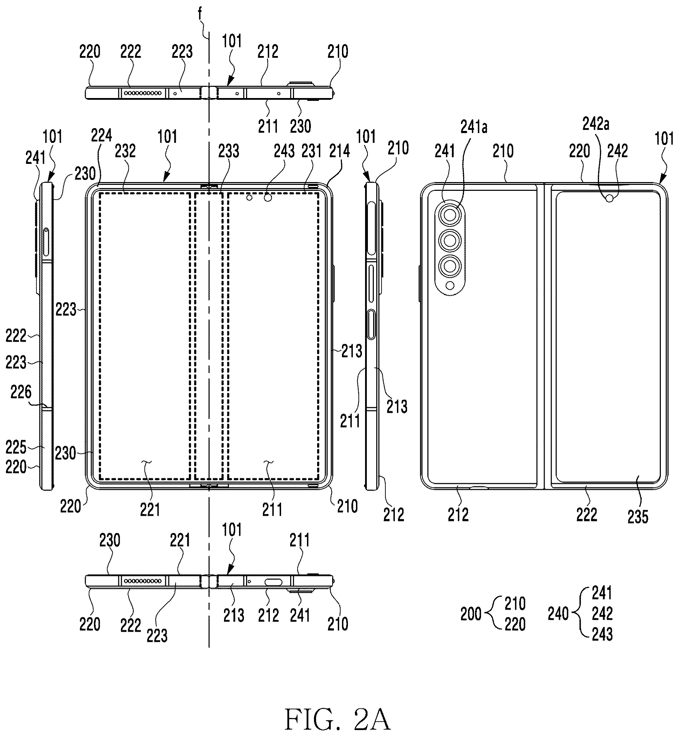

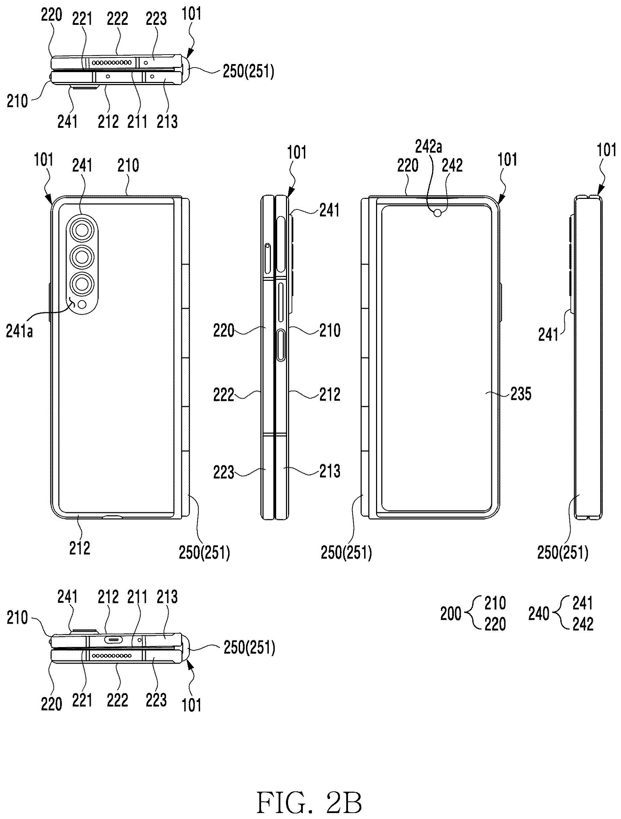

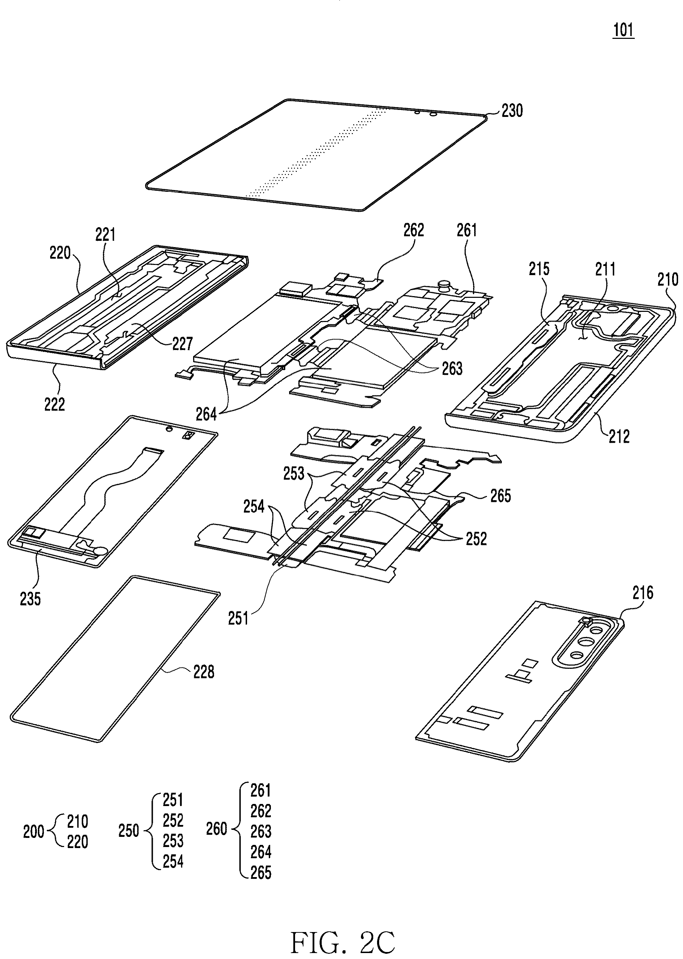

FIG. 2A illustrates an unfolded state of an exemplary electronic device (e.g. the electronic device 101 in accordance with FIG. 1). FIG. 2B illustrates a folded state of an exemplary electronic device (e.g. the electronic device 101 in accordance with FIG. 1). FIG. 2C is an exploded view of an exemplary electronic device (e.g. the electronic device 101 in accordance with FIG. 1).

Referring to FIGS. 2A, 2B, and 2C, an electronic device 101 may include a housing 200 including a first housing part 210 and a second housing part 220, a display 230, at least one camera 240 (e.g., the camera module 180 of FIG. 1), a hinge structure 250, and/or at least one electronic component 260.

The first housing part 210 and the second housing part 220 may form at least a portion of an outer surface of the electronic device 101 that may be gripped by a user. At least a portion of the outer surface of the electronic device 101 defined by the first housing part 210 and the second housing part 220 may contact a part of a body of the user when the electronic device 101 is used by the user. According to an embodiment, the first housing part 210 may include a first front surface 211, a first rear surface 212 facing the first front surface 211 and spaced apart from the first front surface 211, and one or more first side surfaces 213 covering at least a portion of the first front surface 211 and the first rear surface 212. In another arrangement, it may be considered that the first front surface 211 faces away from the first rear surface 212, e.g. the first front surface 211 faces a first direction and the first rear surface 212 faces a second direction opposite to the first direction. The first side surfaces 213 may connect a periphery of the first front surface 211 to a periphery of the first rear surface 212. The first front surface 211, the first rear surface 212, and the first side surfaces 213 may define an inner space of the first housing part 210. According to an embodiment, the first housing part 210 may provide a space formed by the first front surface 211, the first rear surface 212, and the first side surfaces 213 as a space (or environment, region, volume etc.) for disposing or providing components of the electronic device 101. For example, components (e.g. at least one component) may be disposed within the space (e.g. the inner space) formed, or bounded, by the first front surface 211, the first rear surface 212, and the first side surfaces 213.

The second housing part 220 may include a second front surface 221, a second rear surface 222 facing the second front surface 221 and spaced apart from the second front surface 221, and one or more second side surfaces 223 covering at least a portion of the second front surface 221 and the second rear surface 222. In another arrangement, it may be considered that the second front surface 221 faces away from the second rear surface 222, e.g. the second front surface 221 faces a third direction and the second rear surface 222 faces a fourth direction opposite to the third direction. The second side surfaces 223 may connect a periphery of the second front surface 221 to a periphery of the second rear surface 222. The second front surface 221, the second rear surface 222, and the second side surfaces 223 may define an inner space of the second housing part 220. According to an embodiment, the second housing part 220 may provide a space formed by the second front surface 221, the second rear surface 222, and the second side surfaces 223 covering at least a portion of the second front surface 221 and the second rear surface 222 as a space (or environment, region, volume etc.) for mounting or providing the components of the electronic device 101. For example, components (e.g. at least one component) may be disposed within the space (e.g. the inner space) formed, or bounded, by the second front surface 221, the second rear surface 222, and the second side surfaces 223. According to an embodiment, the second housing part 220 may be coupled to the first housing part 210 to be rotatable with respect to the first housing part 210.

Each of the first housing part 210 and the second housing part 220 may include a first protective member 214 and a second protective member 224, respectively. The first protective member 214 and the second protective member 224 may be disposed on the first front surface 211 and the second front surface 221 along a periphery (e.g. an edge, rim, bezel etc.) of the display 230. According to an embodiment, the first protective member 214 and the second protective member 224 may prevent inflow of a foreign material (e.g., dust or moisture) through a gap between the display 230, and the first housing part 210 and the second housing part 220. For example, the first protective member 214 may surround a periphery of a first display portion 231 of the display 230, and the second protective member 224 may surround a periphery of a second display portion 232 of the display 230. The first protective member 214 may be formed by being attached to the first side surfaces 213 of the first housing part 210, or may be formed integrally with the first side surfaces 213. The second protective member 224 may be formed by being attached to the second side surfaces 223 of the second housing part 220, or may be formed integrally with the second side surfaces 223.

The one of more first side surfaces 213 and the one or more second side surfaces 223 may include a conductive material, a non-conductive material, or a combination thereof. For example, the second side surfaces 223 may include at least one conductive portion 225 and at least one non-conductive portion 226. At least one conductive portion 225 may include a plurality of conductive portions spaced apart from each other. At least one non-conductive portion 226 may be disposed between a plurality of conductive portions. The plurality of conductive portions may be isolated (or disconnected) from each other by the at least one non-conductive portion 226 disposed between the plurality of conductive portions. According to an embodiment, a plurality of conductive portions and a plurality of non-conductive portions may form an antenna radiator together. The electronic device 101 may be capable of communicating with an external electronic device through an antenna radiator formed by a plurality of conductive portions and a plurality of non-conductive portions.

The display 230 may be configured to display visual information. According to an embodiment, the display 230 may be disposed on the first front surface 211 of the first housing part 210 and the second front surface 221 of the second housing part 220 across the hinge structure 250. For example, the display 230 may include a first display portion 231 disposed on the first front surface 211 of the first housing, a second display portion 232 disposed on the second front surface 221 of the second housing, and a third display portion 233 disposed between the first display portion 231 and the second display portion 232. The first display portion 231, the second display portion 232, and the third display portion 233 may form a front surface of the display 230. According to an embodiment, the display 230 may further include a sub-display 235 disposed on the second rear surface 222 of the second housing part 220. For example, the display 230 may be referred to as a flexible display. According to an embodiment, the display 230 may include a window exposed toward the outside of the electronic device 101. The window may protect a surface of the display 230 and transmit visual information provided by the display 230 to the outside of the electronic device 101 by including a substantially transparent material. For example, the window may include glass (e.g., ultra-thin glass (UTG)) and/or polymer (e.g., polyimide (PI)), but is not limited thereto.

At least one camera 240 may be configured to obtain an image based on receiving light from a subject outside the electronic device 101. According to an embodiment, at least one camera 240 may include first cameras 241, a second camera 242, and/or a third camera 243. The first cameras 241 may be disposed on the first housing part 210. For example, the first cameras 241 may be disposed inside the first housing part 210, and at least a portion may be visible through the first rear surface 212 of the first housing part 210. The first cameras 241 may be supported by a bracket (not illustrated) in the first housing part 210. When the first rear surface 212 is viewed from above, the first housing part 210 may include at least one opening 241a that overlaps the first cameras 241. The first cameras 241 may obtain an image based on receiving light from the outside of the electronic device 101 through at least one opening 241a.

The second camera 242 may be disposed in the second housing part 220. For example, the second camera 242 may be disposed inside the second housing part 220 and may be visible through the sub-display 235. When the second rear surface 222 is viewed from above, the second housing part 220 may include at least one opening 242a that overlaps the second camera 242. The second camera 242 may obtain an image based on receiving light from the outside of the electronic device 101 through at least one opening 242a.

The third camera 243 may be disposed on the first housing part 210. For example, the third camera 243 may be disposed inside the first housing part 210, and at least a portion may be visible through the first front surface 211 of the first housing part 210. For another example, the third camera 243 may be disposed inside the first housing part 210, and at least a portion may be visible through the first display portion 231 of the display 230. When the display 230 is viewed from above, the first display portion 231 of the display 230 may include at least one opening (not illustrated) that overlaps the third camera 243. The third camera 243 may obtain an image based on receiving light from the outside of the display 230 through at least one opening.

The second camera 242 and the third camera 243 may be disposed below (e.g., in a direction toward the inside of the first housing part 210 or the inside of the second housing part 220) the display 230. For example, the second camera 242 and the third camera 243 may be an under display camera (UDC). In case that the second camera 242 and the third camera 243 are under display cameras, an area of the display 230 corresponding to respective positions of the second camera 242 and the third camera 243 may not be an inactive area. For example, in case that the second camera 242 and the third camera 243 are under-display cameras, the area of the display 230 corresponding to the respective positions of the second camera 242 and the third camera 243 may have a pixel density lower than that of another area of the display 230. The inactive area of the display 230 may mean an area of the display 230 that does not include pixels or does not emit light to the outside of the electronic device 101. For another example, the second camera 242 and the third camera 243 may be punch hole cameras. In case that the second camera 242 and the third camera 243 are punch hole cameras, an area of the display 230 corresponding to respective positions of the second camera 242 and the third camera 243 may be an inactive area. For example, in case that the second camera 242 and the third camera 243 are punch-hole cameras, the area of the display 230 corresponding to the respective positions of the second camera 242 and the third camera 243 may include an opening that does not include a pixel.

The hinge structure 250 may rotatably connect (e.g. rotatably couple or movably couple so as to allow for at least partial rotation between) the first housing part 210 and the second housing part 220. The hinge structure 250 may be disposed between the first housing part 210 and the second housing part 220 of the electronic device 101 such that the electronic device 101 may be bent, curved, or folded. For example, the hinge structure 250 may be disposed between a portion of the first side surfaces 213 and a portion of the second side surfaces 223 facing each other. For example, the hinge structure 250 may be disposed between a part, or portion, of an edge or side surface (e.g. of the first side surfaces 213) of the first housing part 210 that faces an edge or side surface (e.g. of the second side surfaces 223) of the second housing part 220. The hinge structure 250 may be configured to change the electronic device 101 between folded and unfolded states. The hinge structure 250 may be capable of changing the electronic device 101 into an unfolded state in which the first front surface 211 of the first housing part 210 and the second front surface 221 of the second housing part 220 are directed in substantially the same direction as each other, or a folded state in which the first front surface 211 and the second front surface 221 face each other. When the electronic device 101 is in a folded state, the first housing part 210 and the second housing part 220 may be stacked or overlapped by facing each other.

When the electronic device 101 is in the folded state, a direction in which the first front surface 211 faces and a direction in which the second front surface 221 faces may be different from each other. For example, when the electronic device 101 is in the folded state, the direction in which the first front surface 211 faces and the direction in which the second front surface 221 faces may be opposite to each other. For example, the first housing part 210 and the second housing part 220 may be folded inwardly around the hinge structure, and the first front surface 211 and the second front surface 221 may face toward each other in the folded state. For another example, when the electronic device 101 is in the folded state, the direction in which the first front surface 211 faces and the direction in which the second front surface 221 faces may be inclined with respect to each other. In case that the direction in which the first front surface 211 faces is inclined with respect to the direction in which the second front surface 221 faces, the first housing part 210 may be inclined with respect to the second housing part 220. However, it is not limited thereto. For example, in the folded state of the electronic device 101, the first rear surface 212 of the first housing part 210 may face the second rear surface 222 of the second housing part 220 (e.g. here the electronic device folds in an opposite direction to that shown in FIG. 2B). In case that the first rear surface 212 and the second rear surface 222 face each other in the folded state of the electronic device 101, the direction in which the first front surface 211 faces and the direction in which the second front surface 221 faces may be opposite to each other. In case that the first rear surface 212 and the second rear surface 222 face each other in the folded state of the electronic device 101, the display 230 may be directly exposed to the outside in the folded state of the electronic device 101. For example, the first housing part 210 and the second housing part 220 may be folded outwardly around the hinge structure, and the first front surface 211 and the second front surface 212 may each face outwards (e.g. toward the outside) in the folded state.

The electronic device 101 may be foldable based on a folding axis (f). The folding axis (f) may mean a virtual line extending through a hinge cover 251 in a direction substantially parallel to a longitudinal direction of the electronic device 101, but is not limited thereto. For example, the folding axis (f) may be a virtual line extending in a direction substantially perpendicular to the longitudinal direction of the electronic device 101. In case that the folding axis (f) extends in the direction substantially perpendicular to the longitudinal direction of the electronic device 101, the hinge structure 250 may connect the first housing part 210 and the second housing part 220 by extending in a direction parallel to the folding axis (f). The first housing part 210 and the second housing part 220 may be rotatable by the hinge structure 250 extending in the direction substantially perpendicular to the longitudinal direction of the electronic device 101.

The hinge structure 250 may include the hinge cover 251, a first hinge plate 252, a second hinge plate 253, and a hinge module 254. The hinge cover 251 may cover internal components of the hinge structure 250 and form an outer surface of the hinge structure 250. According to an embodiment, when the electronic device 101 is in the folded state, at least a portion of the hinge cover 251 covering the hinge structure 250 may be visually exposed to the outside of the electronic device 101 through the space between the first housing part 210 and the second housing part 220. According to an embodiment, when the electronic device 101 is in the unfolded state, the hinge cover 251 may not be visually exposed to the outside of the electronic device 101 by being obscured by the first housing part 210 and the second housing part 220.

The first hinge plate 252 and the second hinge plate 253 may rotatably connect the first housing part 210 and the second housing part 220 by being coupled to the first housing part 210 and the second housing part 220, respectively. For example, the first hinge plate 252 may be coupled to a first bracket 215 of the first housing part 210, and the second hinge plate 253 may be coupled to a second bracket 227 of the second housing part 220. As the first hinge plate 252 and the second hinge plate 253 are coupled to the first bracket 215 and the second bracket 227, respectively, the first housing part 210 and the second housing part 220 may be rotatable according to rotation of the first hinge plate 252 and the second hinge plate 253.

The hinge module 254 may rotate the first hinge plate 252 and the second hinge plate 253. For example, the hinge module 254 may rotate the first hinge plate 252 and the second hinge plate 253 based on the folding axis (f) by including gears that are rotatable by being engaged with each other. According to an embodiment, the hinge module 254 may be plural or may include a plurality of components. For example, a plurality of hinge modules 254 may be disposed to be spaced apart from each other at both ends of the first hinge plate 252 and the second hinge plate 253, respectively.

The first housing part 210 may include the first bracket 215 and a first cover 216, and the second housing part 220 may include the second bracket 227 and a second cover 228. The first bracket 215 and the first cover 216 may support components of the electronic device 101. The first bracket 215 may define the first housing part 210 by being coupled to the first cover 216. The first cover 216 may define a portion of an outer surface of the first housing part 210. The second bracket 227 and the second cover 228 may support components of the electronic device 101. The second bracket 227 may define the second housing part 220 by being coupled to the second cover 228. The second cover 228 may define a portion of an outer surface of the second housing part 220. For example, the display 230 may be disposed on a surface of the first bracket 215 and a surface of the second bracket 227. The first cover 216 may be disposed on another surface of the first bracket 215 opposite to the surface of the first bracket 215. The second cover 228 may be disposed on another surface of the second bracket 227 opposite to the surface of the second bracket 227. The sub-display 235 may be disposed between the second bracket 227 and the second cover 228.

A portion of the first bracket 215 may be surrounded by the first side surfaces 213, and a portion of the second bracket 227 may be surrounded by the second side surfaces 223. For example, the first bracket 215 may be integrally formed with the first side surfaces 213, and the second bracket 227 may be integrally formed with the second side surfaces 223. For another example, the first bracket 215 may be formed separately from the first side surfaces 213, and the second bracket 227 may be formed separately from the second side surfaces 223.

At least one electronic component 260 may implement various functions to provide to a user. According to an embodiment, at least one electronic component 260 may include a first printed circuit board 261, a second printed circuit board 262, a flexible printed circuit board 263, a battery 264 (e.g., the battery 189 of FIG. 1), and/or an antenna 265 (e.g., the antenna module 197 of FIG. 1). The first printed circuit board 261 and the second printed circuit board 262 may each form electrical connections of components in the electronic device 101. For example, components (e.g., the processor 120 of FIG. 1) for implementing an overall function of the electronic device 101 may be disposed on the first printed circuit board 261, and at least one electronic component for implementing some functions of the first printed circuit board 261 may be disposed on the second printed circuit board 262. For another example, components for an operation of the sub-display 235 disposed on the second rear surface 222 may be disposed on the second printed circuit board 262.

The first printed circuit board 261 may be disposed in the first housing part 210. For example, the first printed circuit board 261 may be disposed on the surface of the first bracket 215. According to an embodiment, the second printed circuit board 262 may be disposed in the second housing part 220. For example, the second printed circuit board 262 may be spaced apart from the first printed circuit board 261 and disposed on the surface of the second bracket 227. The flexible printed circuit board 263 may connect the first printed circuit board 261 and the second printed circuit board 262. For example, the flexible printed circuit board 263 may extend from the first printed circuit board 261 to the second printed circuit board 262.

The battery 264 is a device for supplying power to at least one component of the electronic device 101, and may include, for example, a non-rechargeable primary battery, a rechargeable secondary battery, or a fuel cell. At least a portion of the battery 264 may be disposed on substantially the same plane as the first printed circuit board 261 or the second printed circuit board 262.

The antenna 265 may be configured to receive power or a signal from the outside of the electronic device 101. According to an embodiment, the antenna 265 may be disposed between the first cover 216 and the battery 264. The antenna 265 may include, for example, a near field communication (NFC) antenna, an antenna module, and/or a magnetic secure transmission (MST) antenna. The antenna 265 may, for example, perform short-range communication with an external device or wirelessly transmit and receive power required for charging.

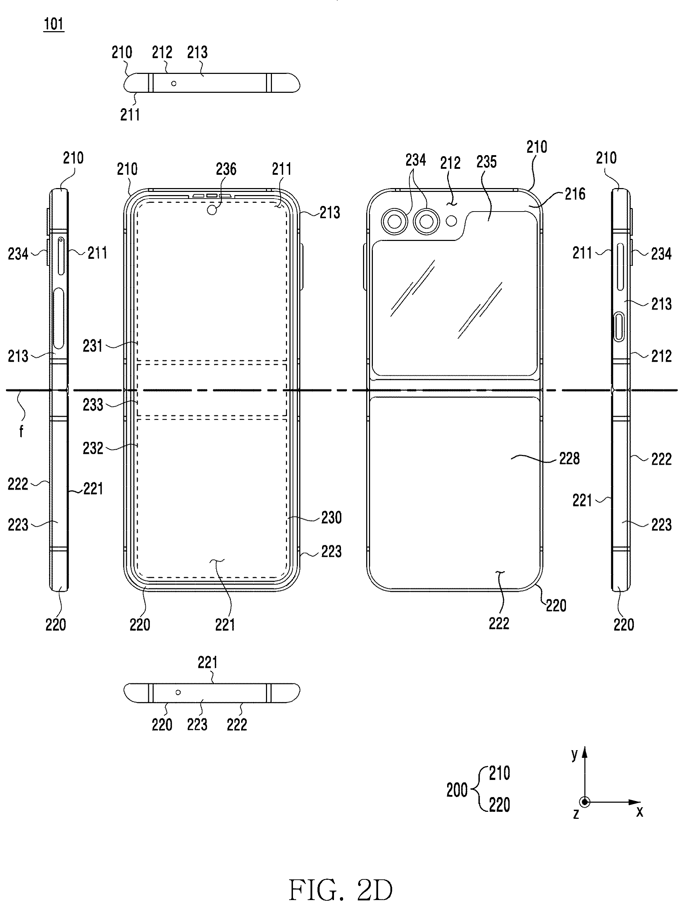

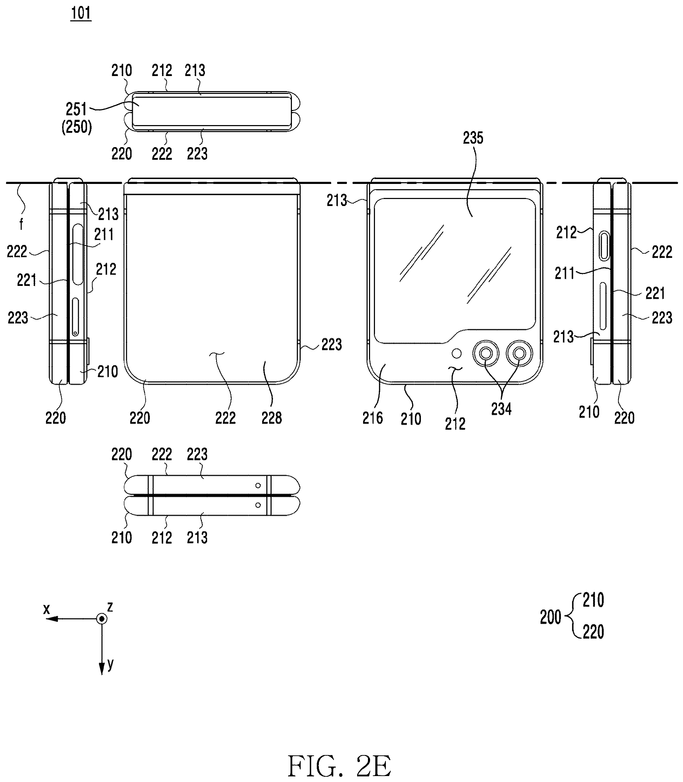

FIG. 2D illustrates an unfolded state of an exemplary electronic device. FIG. 2E illustrates a folded state of an exemplary electronic device.

An electronic device 101 exemplarily illustrated and described in FIGS. 2D and 2E may include a housing 200 including a first housing part 210 and a second housing part 220 rotatable with respect to the first housing part 210, such as the electronic device 101 exemplarily illustrated and described in FIGS. 2A to 2C. The electronic device 101 exemplarily illustrated and described in FIGS. 2D and 2E may be referred to as a foldable electronic device in terms of including a display 230 including a third display portion 233 (a foldable portion) that is deformable by a hinge structure 250 (or a hinge assembly) configured to rotate the second housing part 220 with respect to the first housing part 210, such as the electronic device 101 exemplarily illustrated and described in FIGS. 2A to 2C. For example, FIGS. 2D and 2E, as in FIGS 2A. to 2C, illustrate an example of a foldable electronic device, in that it is foldable about a folding axis (f). For example, a folding axis (f) of the electronic device 101 exemplarily illustrated and described in FIG. 2D and FIG. 2E may be parallel to an x-axis, as illustrated. Unlike the electronic device 101 exemplarily illustrated and described in FIGS. 2D and 2E, the folding axis (f) of the electronic device 101 exemplarily illustrated and described in FIGS. 2A to 2C may be parallel to a y-axis orthogonal to the x-axis. However, the electronic device 101 illustrated and described in FIGS. 2A to 2E may be exemplary, and the electronic device 101 may have various foldable form factors (e.g., a multi-foldable electronic device). Hereinafter, the electronic device 101 exemplarily illustrated in FIGS. 2D and 2E will be described with reference to the description of components having the same reference numeral as in FIGS. 2A to 2C.

The electronic device 101 may include the housing 200 including the first housing part 210 and the second housing part 220, and the hinge structure (or the hinge assembly) 250. The first housing part 210 may be rotatably connected to the hinge structure 250. The first housing part 210 may rotate with respect to the second housing part 220 through the hinge structure 250. The second housing part 220 may be rotatably connected to the hinge structure 250. The second housing part 220 may rotate with respect to the first housing part 210 through the hinge structure 250.

The first housing part 210 may include a first front surface 211, a first rear surface 212 faced away from the first front surface 211, and first side surfaces 213 covering at least a portion of the first front surface 211 and the first rear surface 212. The first housing part 210 may provide a space for disposing components of the electronic device 101. The first housing part 210 may include a conductive material, a non-conductive material, or a combination thereof.

The second housing part 220 may include a second front surface 221, a second rear surface 222 faced away the second front surface 221, and second side surfaces 223 covering at least a portion of the second front surface 221 and the second rear surface 222. The second housing part 220 may provide a space for disposing the components of the electronic device 101.

The hinge structure 250 may be connected to the first housing part 210 and the second housing part 220, respectively. For example, the hinge structure 250 may include a first hinge plate (e.g., the first hinge plate 252 of FIG. 2C) and a second hinge plate (e.g., the second hinge plate 253 of FIG. 2C), which are rotatably configured. The first hinge plate may be connected to the first housing part 210, and the first housing part 210 may be rotated by the first hinge plate. The second hinge plate may be connected to the second housing part 220, and the second housing part 220 may be rotated by the second hinge plate.

According to rotation of the first housing part 210 and the second housing part 220, the electronic device 101 may be folded or unfolded based on the folding axis (f) passing through the hinge structure 250. The hinge structure 250 may be positioned between the first housing part 210 and the second housing part 220 such that the electronic device 101 may be folded based on the folding axis (f).

The hinge structure 250 may include a hinge cover 251 for obscuring an internal structure configuring a mechanism of the hinge structure. The hinge cover 251 may be visually exposed to the outside according to degree to which the electronic device 101 is folded, or may be obscured by the first housing part 210 and the second housing part 220. For example, while the electronic device 101 is in a folded state (e.g., FIG. 2E), the hinge cover 251 may be at least partially exposed through a space between the first housing part 210 and the second housing part 220. For example, while the electronic device 101 is in an unfolded state (e.g., FIG. 2D), the hinge cover 251 may be obscured by the first housing part 210 and the second housing part 220.

The electronic device 101 may include the display 230 (e.g., the display module 160 of FIG. 1) disposed in a space provided by the first housing part 210 and the second housing part 220. For example, the display 230 may be at least partially accommodated in a recess formed in the first front surface 211 of the first housing part 210 and the second front surface 221 of the second housing part 220. The display 230 may include a first display portion 231 (a flat portion) aligned with the first housing part 210, a second display portion 232 spaced apart from the first display portion 231 and aligned with the second housing part 220, and the third display portion 233 aligned with the hinge structure 250 and extending from the first display portion 231 to the second display portion 232. The display 230 may be referred to as a foldable display or a flexible display. The first display portion 231, the second display portion 232, and the third display portion 233 may form a surface of the display 230. The surface of the display 230 may at least partially form the first front surface 211 of the first housing part 210 and the second front surface 221 of the second housing part 220. The first display portion 231, the second display portion 232, and the third display portion 233 may respectively define a first display area, a second display area, and a third display area of the display 230 on which visual information may be displayed.

The electronic device 101 may include a sub-display 235 (e.g., the display module 160 of FIG. 1) disposed in the first housing part 210. The sub-display 235 may be viewed through the second rear surface 222 of the first housing part 210.

The electronic device 101 may include a plurality of cameras (e.g., the camera module 180 of FIG. 1). For example, the electronic device 101 may include cameras 234 and 236. The camera 234 may be disposed in the first housing part 210 to obtain an image through a portion of the first rear surface 212. The camera 236 may be disposed under the first display portion 231 of the display 230. The camera 236 may be aligned with an opening that at least partially penetrates the first display portion 231, and may obtain an image through the hole. The camera 236 may be positioned in a screen display area of the display 230, but is not limited thereto.

Hereinafter, states of the electronic device 101 will be described. The electronic device 101 may include a plurality of states including an unfolded state (e.g., FIGS. 2A and 2D) and a folded state (e.g., FIGS. 2B and 2E). The electronic device 101 may be transformed or changed in the unfolded state and the folded state. Additionally, the electronic device 101 may include a plurality of intermediate states between the unfolded state and the folded state. An angle between the first housing part 210 and the second housing part 220 may vary according to a state of the electronic device 101.

Referring to FIG. 2E, the unfolded state of the electronic device 101 may be referred to as the unfolded state of the first housing part 210 and the second housing part 220. For example, the unfolded state (e.g. FIG. 2D) may be a state that may be changed into a plurality of folded states. For example, the unfolded state may be a state in which the first housing part 210 and the second housing part 220 are substantially planar as the housing 200 is unfolded (e.g. the first housing part 210 and the second housing part 220 may be arranged, or disposed, on a same plane, so as the first display portion 231, the second display portion 232, and the third display portion 233 form a substantially flat surface). For example, the unfolded state may be a state in which the deformable third display portion 233 of the display 230 is unfolded. For example, in the unfolded state of the electronic device 101, the first housing part 210 and the second housing part 220 may form a first angle (e.g. an angle between the first housing part 210 and the second housing part 220, about the folding axis (f)). The first angle may be approximately 180 degrees. The first display portion 231, the second display portion 232, and the third display portion 233 of the display 230 may form a surface that is substantially planar. A direction (e.g., +z direction) in which the first front surface 211 (or the first display portion 231) of the first housing part 210 faces and a direction (e.g., +z direction) in which the second front surface 221 (or the second display portion 232) of the second housing part 220 faces may be substantially the same.

Referring to FIG. 2E, in the folded state of the electronic device 101, the first housing part 210 and the second housing part 220 may be folded to face each other by rotating based on the folding axis (f). The first housing part 210 and the second housing part 220 may be overlapped (e.g. folded, or stacked) with each other to form a second angle (e.g. an angle between the first housing part 210 and the second housing part 220, about the folding axis (f))) smaller than the first angle (e.g. smaller than180 degrees). For example, the second angle may be approximately 0°. The third display portion 233 of the display 230 may be bent to correspond to the second angle. For example, the third display portion 233, that is a foldable or deformable portion, may form the second angle about the folding axis (f)). The first front surface 211 of the first housing part 210 may face the second front surface 221 of the second housing part 220 or may overlap the second front surface 221. The first housing part 210 and the second housing part 220 may at least partially contact each other, but is not limited thereto. The direction (e.g., +z direction) in which the first front surface 211 of the first housing part 210 faces and the direction (e.g., -z direction) in which the second front surface 221 of the second housing part 220 faces may be opposite to each other. In the unfolded state, at least a portion of the display 230 may not be visible outside the electronic device 101, and the sub-display 235 may be visible outside the electronic device 101.

Although not illustrated, the electronic device 101 may be in a plurality of intermediate states between the unfolded state and the folded state. For example, the intermediate states may be states in which the second housing part 220 is inclined (e.g. angled, non-linear) with respect to the first housing part 210. For example, the intermediate states may be states in which the second front surface (e.g., the second front surface 221 of FIG. 2A) of the second housing part 220 is inclined with respect to the first front surface (e.g., the first front surface 211 of FIG. 2A) of the first housing part 210. The intermediate states may be states in which the first front surface 211 and the second front surface 221 face substantially different directions. For example, the intermediate states may be states in which the first display portion 231 on the first housing part 210 of the display 230 faces a different direction from the second display portion 232 on the second housing part 220. For example, the intermediate states may be states in which the third display portion 233 between the first display portion 231 and the second display portion 232 is at least partially bent. For example, the intermediate states may include states in which an angle between the first housing part 210 and the second housing part 220 is positioned in a range of greater than 0 degrees and less than 180 degrees.

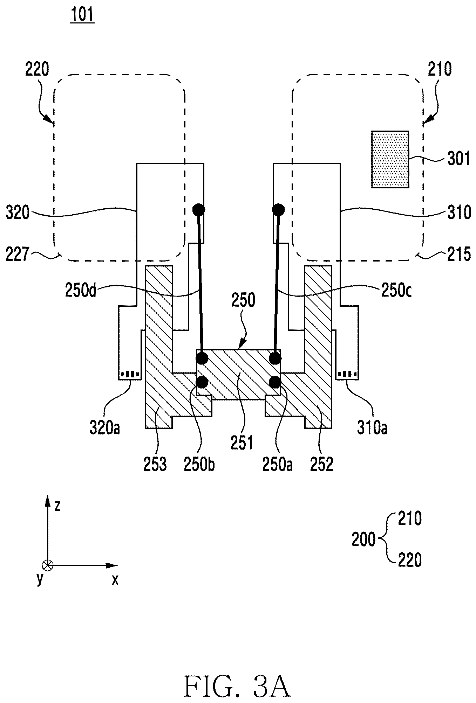

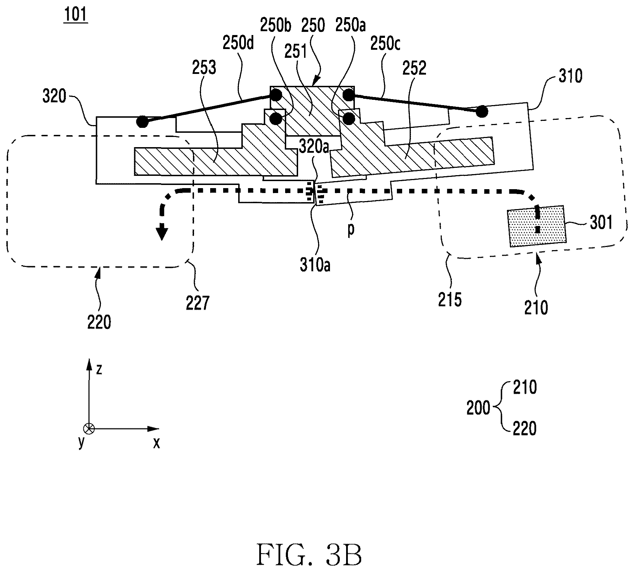

FIG. 3A illustrates a portion of an exemplary electronic device in a folded state. FIG. 3B illustrates a portion of an exemplary electronic device in an unfolded state. The electronic device of FIG. 3A and FIG. 3B may be in accordance with electronic device 101 of FIG. 1, FIGS. 2A-2C or FIGS. 2D-2E.

Referring to FIGS. 3A and 3B, an electronic device 101 may include a housing 200 including a first housing part 210 and a second housing part 220, a hinge structure 250, and an electronic component 301.

The first housing part 210 may include a first plate 310 (or first heat-conductive plate 310). The second housing part 220 may include a second plate 320 (or second heat-conductive plate 320).

For example, the first plate 310 may be a portion of the first housing part 210 coupled to a hinge structure 250. For example, the first plate 310 may be configured to rotate the first housing part 210 with respect to the hinge structure 250 by being rotatably coupled to the hinge structure 250. For example, the first plate 310 may be provided as a portion of a first bracket 215 in the first housing part 210 to be coupled to the hinge structure 250 or fastened to the first bracket 215, but examples of the present disclosure are not limited thereto. For example, the first plate 310 may receive at least a portion of heat emitted from the electronic component 301 in the first housing part 210. In examples, the electronic component 301 may be one or more components.

For example, the second plate 320 may be a portion of the second housing part 220 coupled to the hinge structure 250. For example, the second plate 320 may be configured to rotate the second housing part 220 with respect to the hinge structure 250 by being rotatably coupled to the hinge structure 250. For example, the second plate 320 may be provided as a portion of a second bracket 227 in the second housing part 220 to be coupled to the hinge structure 250 or fastened to the second bracket 227, but examples of the present disclosure are not limited thereto.

The electronic component 301 may be disposed in the housing 200. For example, the electronic component 301 may be disposed in the first housing part 210, as illustrated. The electronic component 301, for example, may be mounted on a printed circuit board (e.g., the first printed circuit board 261 of FIG. 2C) in the first housing part 210. For example, as the electronic device 101 operates, heat may be generated from the electronic component 301. At least a portion of the heat emitted from the electronic component 301 may be transferred to the first plate 310 of the first housing part 210. For example, the electronic component 301 may be referred to as a processor (e.g., the processor 120 of FIG. 1) and/or a battery (e.g., the battery 189 of FIG. 1 and the battery 264 of FIG. 2C) of the electronic device 101, but is not limited thereto. For example, the electronic component 301 may include a circuit (e.g., a charging circuit, and a communication circuit) that generates a relatively high amount of heat.

The electronic component 301 is illustrated and described as being disposed in the first housing part 210 of the housing 200, but it should be noted that this is merely exemplary and is not intended to limit placement of the electronic component 301 in the housing 200. For example, the electronic component 301 may be disposed in the second housing part 220 of the housing 200.

The electronic device 101 may include a display 230 including a first display portion (e.g., the first display portion 231 of FIG. 2A) coupled to the first housing part 210, a second display portion (e.g., the second display portion 232 of FIG. 2A) coupled to the second housing part 220, and a third display portion (e.g., the third display portion 233 of FIG. 2A) extending from the first display portion 231 to the second display portion 232 and configured to be bent by (or folded in accordance with) the hinge structure 250 in a folded state of the electronic device 101. For example, the first display portion 231 may be disposed above the first bracket 215 of the first housing part 210. The second display portion 232 may be disposed above the second bracket 227 of the second housing part 220 and may be spaced apart from the first display portion 231. The third display portion 233 may be disposed above the hinge structure 250. The third display portion 233 may be configured to be transformed while a state of the electronic device 101 changes. For example, the third display portion 233 may be at least partially transformed by the first housing part 210 and/or the second housing part 220 that is rotated by the hinge structure 250. For example, the third display portion 233 may be disposed on the first plate 310 of the first housing part 210 and the second plate 320 of the second housing part 220. The third display portion 233 may be at least partially transformed by the first plate 310 and/or the second plate 320.

The hinge structure 250 may rotatably couple the first housing part 210 and the second housing part 220. The hinge structure 250 may be configured to provide a plurality of states including a folded state and an unfolded state of the electronic device 101 by rotatably coupling the first plate 310 and the second plate 320. The hinge structure 250 may also provide intermediate states (e.g. partially folded states, between an unfolded state and a fully folded state) of the electronic device 101 by rotatably coupling the first plate 310 and the second plate 320.

For example, the first plate 310 may be coupled to the hinge structure 250 to be rotatable with respect to the second plate 320 based on (e.g. about) the folding axis (e.g., the folding axis (f) of FIG. 2A). The second plate 320 may be coupled to the hinge structure 250 to be rotatable with respect to the first plate 310. For example, the first housing part 210 may be coupled to the hinge structure 250 to be rotatable with respect to the second housing part 220 through the first plate 310. The second housing part 220 may be coupled to the hinge structure 250 to be rotatable with respect to the first housing part 210 through the second plate 320. For example, the first plate 310 and the second plate 320 may face each other based on the hinge structure 250.

For example, the hinge structure 250 may include a first hinge plate 252 coupled to the first housing part 210 (e.g. coupled to a first plate 310 of the first housing part 210) and a second hinge plate 253 coupled to the second housing part 220 (e.g. coupled to the second plate 320 of the second housing part 220). For example, the first hinge plate 252 may be linked with (or coupled to) the first plate 310 such that the first plate 310 rotates according to rotation of the first hinge plate 252. The second hinge plate 253 may be linked with (or coupled to) the second plate 320 such that the second plate 320 rotates according to rotation of the second hinge plate 253. In various embodiments, the first hinge plate 252 may be integrally formed with the first plate 310, and/or the second hinge plate 253 may be integrally formed with the second plate 320.

For example, the hinge structure 250 may include a hinge cover 251 to which the first hinge plate 252 and the second hinge plate 253 are rotatably coupled. The hinge cover 251 may provide a central axis (e.g., the folding axis (f) of FIG. 2A) in which the first hinge plate 252 and the second hinge plate 253 rotate with respect to each other (e.g. are arranged to rotate, or be rotatably coupled, about the central axis at the hinge cover 251).

For example, the hinge structure 250 may include a first link 250a (alternatively, a first hinge pin 250a, or first pivot 250a) connecting the first hinge plate 252 and the hinge cover 251 and a second link 250b (a second hinge pin 250b, or second pivot 250b) connecting the second hinge plate 253 and the hinge cover 251. The first link 250a may provide a rotational axis such that the first hinge plate 252 is rotatable based on the hinge cover 251. The second link 250b may provide a rotational axis such that the second hinge plate 253 is rotatable based on the hinge cover 251. The hinge cover 251 may rotatably couple the first hinge plate 252 and the second hinge plate 253 by providing the first link 250a and the second link 250b. That is, in other words, the first hinge plate 252 may be arranged to rotate, or pivot, about the first link 250a (providing the rotational axis), in a clockwise direction, and the second hinge plate 253 may be configured to rotate, or pivot, about the second link 250b (providing a rotational axis), in an anticlockwise direction.

For example, the first plate 310 may be slidably coupled to the first hinge plate 252. The second plate 320 may be slidably coupled to the second hinge plate 253. For example, the hinge structure 250 may include a third link 250c (alternatively, a first hinge rod 250c, or first link part 250c) connecting the first plate 310 and the hinge cover 251 and a fourth link 250d (alternatively, a second hinge rod 250d, or second link part 250d) connecting the second plate 320 and the hinge cover 251. For example, while the first hinge plate 252 rotates with respect to the hinge cover 251 through the (e.g. about the) first link 250a, the first plate 310 may slide with respect to the first hinge plate 252 through the third link 250c. For example, while the second hinge plate 253 rotates with respect to the hinge cover 251 through the (e.g. about the) second link 250b, the second plate 320 may slide with respect to the second hinge plate 253 through the fourth link 250d. For example, the first plate 310 and the second plate 320 are rotatably coupled and slidably coupled to the hinge cover 251 via the first hinge plate 252 and the second hinge plate 253, respectively.

For example, when referring to FIG. 3A and FIG. 3B sequentially, the first plate 310 may slide toward the second plate 320 with respect to the first hinge plate 252 while the electronic device 101 changes from a folded state to an unfolded state. In other words, when the first housing part 210 and the second housing part 220 rotate about the central axis, the first plate 310 and second plate 320 may rotate about the same axis (or about axes which are parallel to one another but laterally offset) such that at least a portion of the first plate 310 (e.g. first surface 310a) and the second plate (e.g. second surface 320a) moves (or rotate and/or slide) toward each other in accordance with the rotation. The second plate 320 may slide toward the first plate 310 with respect to (e.g. according to the movement or rotation of) the second hinge plate 253. For example, while the electronic device 101 changes from a folded state to an unfolded state, the first plate 310 may be moved toward the second plate 320 by sliding with respect to (e.g. according to the movement or rotation of) the first hinge plate 252 through the third link 250c. The second plate 320 may be moved toward the first plate 310 by sliding with respect to the second hinge plate 253 through the fourth link 250d. The plates 310 and 320 may be in contact with each other in the unfolded state of the electronic device 101 by sliding with respect to the hinge plates 252 and 253, respectively.

The first plate 310 may be configured to be in contact with the second plate 320 in an unfolded state of the electronic device 101 such that the first plate 310 and the second plate 320 form a heat conduction path (p) between the first housing part 210 and the second housing part 220 for heat generated from the electronic component 301. For example, referring to FIG. 3A, the first plate 310 and the second plate 320 may be spaced apart from each other. Referring to FIG. 3B, the first plate 310 and the second plate 320 may be in contact with each other by facing each other. For example, in the unfolded state of the electronic device 101, a first surface 310a of the first plate 310, facing the second plate 320, may be in contact with a second surface 320b of the second plate 320, facing the first plate 310. As the first surface 310a and the second surface 320a are in contact with each other, the heat conduction path (p) of heat generated from the electronic component 301 may be formed by the plates 310 and 320. For example, the plates 310 and 320 may be formed from a material (e.g., metal) that has relatively high heat conductivity to increase heat conductivity of the heat conduction path (p). The plates 310 and 320 may be referred to as heat-conductive plates, respectively, in that they are plates for the heat conduction path (p), but an embodiment supported by the present disclosure is not limited thereto.

For example, in case that the electronic component 301 is disposed in the first housing part 210 as illustrated, the heat generated from the electronic component 301 may be conducted to the first plate 310 of the first housing part 210. In the unfolded state of the electronic device 101, the heat conducted from the electronic component 301 to the first plate 310 may be diffused into the second housing part 220 through the second plate 320 in contact with the first plate 310. As heat generated in the first housing part 210 is diffused into the second housing part 220 through the plates 310 and 320, the electronic device 101 may improve heat dissipation performance for the heat generated from the electronic component 301. However, an embodiment supported by the present disclosure is not limited thereto.

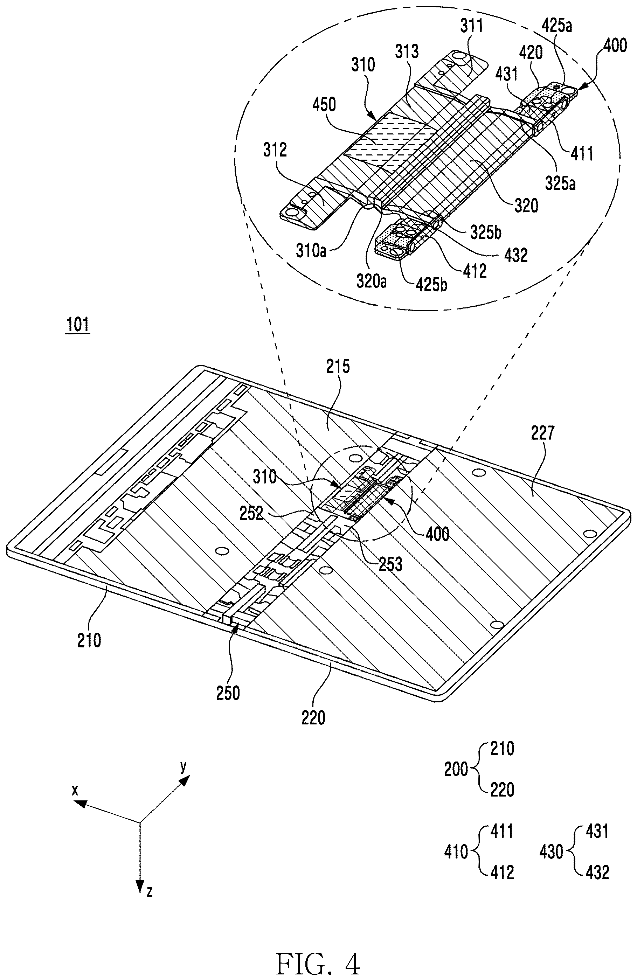

When referring to FIGS. 3A and 3B sequentially, since the plates 310 and 320 are slidably coupled to the hinge plates 252 and 253, respectively, a poor contact between the plates 310 and 320 may occur due to a sliding operation of each of the plates 310 and 320 while the electronic device 101 changes from a folded state to an unfolded state. For example, referring to FIG. 3B, the first surface 310a of the first plate 310 and the second surface 320a of the second plate 320 may be in misaligned contact with each other in the unfolded state. Heat conductivity of a heat conduction path (p) for heat generated from the electronic component 301 between the first housing part 210 and the second housing part 220 may decrease, due to the poor contact between the plates 310 and 320. The electronic device 101 may require a structure that guides a position of the plates 310 and 320 for alignment contact of the plates 310 and 320 in the unfolded state while changing from the folded state to the unfolded state. For example, a structure for facilitating alignment between the plates 310, 320 in the unfolded state when the electronic device 101 is unfolded may be illustrated. The structure will be described through an exemplary illustration in FIG. 4 and below.

FIG. 4 illustrates a portion of an exemplary electronic device in an unfolded state.

Referring to FIG. 4, an electronic device 101 may include a housing 200 including a first housing part 210 (or first housing 210) and a second housing part 220 (or second housing 220), an electronic component (e.g., the processor 120 of FIG. 1 and the electronic component 301 of FIG. 3A) disposed in the housing 200 (or at least one electronic component provided in one of the first housing part 210 and the second housing part 220), and a hinge structure 250 that rotatably couples the first housing part 210 and the second housing part 220. The first housing part 210 may include a first plate 310. The second housing part 220 may include a second plate 320 and an elastic member 410 (or elastic portion 410, or resiliently deformable member 410). In various examples, the second plate 320 and the elastic member 410 may be included in a guide assembly 400 included in the second housing part 220. The first plate 310 may be configured to be in contact with the second plate 320 in an unfolded state of the electronic device 101 such that the first plate 310 and the second plate 320 form a heat conduction path (e.g., the heat conduction path (p) of FIG. 3B) between first housing part 210 and the second housing part 220 for heat generated from the electronic component 301. However, an embodiment supported by the present disclosure is not limited thereto, and the electronic device 101 exemplarily illustrated and described in FIG. 4 may include structures and/or configurations of the electronic device 101 exemplarily illustrated and described in FIGS. 2A to 3B. Additionally, hereinafter, a redundant description of structures and/or configurations having the same reference numeral as the structures and/or the configurations described in FIGS. 2A to 3B may be omitted. For example, the description of the electronic device 101 of FIG. 4 may overlap with the description of an electronic device illustrated in FIGS. 1, 2A-2C, 2D-2E or 3A-3B, with the exception of features provided to address the technical problem associated with the electronic device, or hinge structure 250, described above in relation to FIGS. 3A-3B.

The guide assembly 400 may be coupled to the second housing part 220. The guide assembly 400 may be configured to guide a position of the second plate 320 of the guide assembly 400 with respect to the first plate 310 (e.g. as the electronic device moves to the folded state). For example, the elastic member 410 may be arranged to guide a position of the second plate 320 with respect to the first plate 310. For example, the first plate 310 may be slidably coupled to a first hinge plate 252 of the hinge structure 250. The guide assembly 400 may be slidably coupled to a second hinge plate 253 of the hinge structure 250. The second plate 320 may shift to have displacement with respect to the guide assembly 400 that slides with respect to the second hinge plate 253. For example, the second plate 320 may have a degree of freedom with respect to the guide assembly 400 in the guide assembly 400, e.g. the second plate 320 may move with respect to the guide assembly 400. As the second plate 320 is configured to have a degree of freedom with respect to the guide assembly 400, the guide assembly 400 may guide the position of the second plate 320 with respect to the first plate 310 while the electronic device 101 changes from a folded state to an unfolded state. A structure of the guide assembly 400 will be exemplarily described.

The elastic member 410 of the guide assembly 400 may provide a force, e.g. a repulsion force, to the second plate 320 toward the first plate 310 with respect to a force exerted to the first plate 310 from the second plate 320 in the unfolded state of the electronic device 101 such that the second plate 320 is closely contacted with the first plate 310. For example, the elastic member 410 may press or push the second plate 320 toward the first plate 310 in the unfolded state of the electronic device 101. For example, the elastic member 410 may be configured to be elastically transformed by the second plate 320 in the guide assembly 400. The elastic member 410 may provide a repulsion force (e.g., an elastic force or a restoring force) to the second plate 320 with respect to a force exerted from the second plate 320. The second plate 320 may be closely contacted with the first plate 310 by said force (e.g. the repulsion force) in the unfolded state of the electronic device 101. For example, the elastic member 410 may be in contact with the second plate 320 or may be coupled with the second plate 320 in the guide assembly 400. For example, the elastic member 410 may be in contact with a surface opposite to a second surface 320a of the second plate 320, which is configured to be in contact with the first plate 310, or may press the second plate 320 toward the first plate 310 by being coupled to the surface. However, embodiments of the present disclosure are not limited thereto.

For example, while the electronic device 101 changes from the folded state to the unfolded state, the elastic member 410 may provide an aligned contact (for example, a contact where respective surfaces are flush against one another) between a first surface 310a of the first plate 310 sliding with respect to the first hinge plate 252 toward the second plate 320 and the second surface 320a of the second plate 320 of the guide assembly 400 sliding with respect to the second hinge plate 253. For example, while the electronic device 101 changes from a folded state to an unfolded state, the first plate 310 and the guide assembly 400 may slide with respect to the hinge plates 252 and 253, respectively. The second surface 320a of the second plate 320 may be in contact with the first surface 310a of the first plate 310 that slides with respect to the first hinge plate 252 by moving along the guide assembly 400 that slides with respect to the second hinge plate 253. Since the second plate 320 has a degree of freedom to be shiftable in the guide assembly 400, the second plate 320 may shift with respect to the guide assembly 400 by contact between the first surface 310a and the second surface 320a while the guide assembly 400 slides with respect to the second hinge plate 253. While the second plate 320 shifts in the guide assembly 400 by contact of the surfaces 310a and 320a of the plates 310 and 320, the elastic member 410 may adjust a position of the second plate 320 such that the second surface 320a of the second plate 320 is in aligned contact with the first surface 310a of the first plate 310 while pressing the second plate 320 toward the first plate 310. However, embodiments of the present disclosure are not limited thereto. In various embodiments, the second plate 320 and the elastic member 410 may be considered as included in the second housing part 220 without provision of a guide assembly, in which case the second plate 320 may be regarded as having a degree of freedom to be movable or shiftable in the second housing part 220 such that the second plate 320 may shift with respect to the second housing part 220 by contact between the first surface 310a and the second surface 320a while a portion of the second housing part 220 slides with respect to the second hinge plate 253; further, while the second plate 320 shifts in the second housing part 220 by contact of the surfaces 310a and 320a of the plates 310 and 320, the elastic member 410 may adjust a position of the second plate 320 such that the second surface 320a of the second plate 320 is in aligned contact with the first surface 310a of the first plate 310 while pressing the second plate 320 toward the first plate 310.

In an example, the elastic member 410 may include a first elastic plate 411 (or first plate 411, or first elastic portion 411) contacting a first end portion 325a of the second plate 320 and a second elastic plate 412 (or second plate 412, or second elastic portion 412) contacting a second end portion 325b opposite the first end portion 325a of the second plate 320. For example, the first end portion 325a of the second plate 320 may define a longitudinal end portion of the second surface 320a of the second plate 320 contacting the first plate 310. The second end portion 325b opposite to the first end portion 325a may define another longitudinal end portion of the second surface 320a. The end portions 325a and 325b may be referred to as longitudinal end portions of the second plate 320, respectively, but embodiments of the present disclosure are not limited thereto. For example, in the unfolded state of the electronic device 101, the first elastic plate 411 may press the first end portion 325a of the second plate 320 toward the first plate 310. The second elastic plate 412 may press the second end portion 325b of the second plate 320 toward the first plate 310. Since the elastic plates 411 and 412 press the ends 325a and 325b of the second plate 320 toward the first plate 310, respectively, the second plate 320 may be in aligned contact with the first plate 310 in an unfolded state of the electronic device 101.

For example, while the electronic device 101 changes from a folded state to an unfolded state, the first end portion 325a of the second plate 320 may contact the first plate 310 before the second end portion 325b contacts the first plate 310 by (e.g. due to or as a result of) the first elastic plate 411 (e.g. a force provided by the first elastic plate 411). Since the second plate 320 is shiftable with respect to the guide plate 420, after the first end portion 325a contacts the first plate 310, the second end portion 325b of the second plate 320 may contact the first plate 310 by (e.g. due to or as a result of) the second elastic plate 412 (e.g. a force provided by the second elastic plate 412). As the end portions 325a and 325b of the second plate 320 are all in contact with the first plate 310, the second surface 320a of the second plate 320 may be in aligned contact with the first surface 310a of the first plate 310. For example, while the electronic device 101 changes from a folded state to an unfolded state, the second end portion 325b of the second plate 320 may contact the first plate 310 before the first end portion 325a by (e.g. due to or as a result of) the second elastic plate 412 (e.g. a force provided by the second elastic plate 412). Since the second plate 320 is movable with respect to the guide plate 420, after the second end portion 325b contacts the first plate 310, the first end portion 325a of the second plate 320 may contact the first plate 310 by (e.g. due to or as a result of) the first elastic plate 411 (e.g. a force provided by the first elastic plate 411). As the ends 325a and 325b of the second plate 320 are all in contact with the first plate 310, the second surface 320a of the second plate 320 may be in aligned contact with the first surface 310a of the first plate 310. However, embodiments of the present disclosure are not limited thereto, and the elastic member 410 may include various elastic structures configured to press the second plate 320 toward the first plate 310 for aligned contact of the plates 310 and 320.

The guide assembly 400 may include the guide plate 420 to which the second plate 320 is movably coupled. For example, the guide plate 420 may provide a portion in which the second plate 320 is seated in the guide assembly 400. The guide plate 420 may be slidably coupled to the second hinge plate 253. For example, the guide plate 420 may be coupled to the second plate 320 so that the second plate 320 may be rotatable or translatable with respect to the guide plate 420. For example, the guide plate 420 may be coupled to the elastic member 410. The elastic member 410 may press the second plate 320 that is slidably coupled to the guide plate 420 by being coupled to the guide plate 420. However, an embodiment supported by the present disclosure is not limited thereto.

For example, the first housing part 210 may include a first bracket 215 that supports a first display portion (e.g., the first display portion 231 of FIG. 2A) of a display (e.g., the display 230 of FIG. 2A). The second housing part 220 may include a second bracket 227 supporting a second display portion (e.g., the second display portion 232 of FIG. 2A) of the display 230. For example, the first plate 310 may be fastened to the first bracket 215. For example, the guide plate 420 of the guide assembly 400 may be fastened to the second bracket 227. For example, the first plate 310 may include a first portion 311 and a second portion 312 coupled to the first bracket 215, and a third portion 313 between the first portion 311 and the second portion 312. The third portion 313 may be a portion configured to be in contact with the second plate 320. For example, similar to the portions 311 and 312 of the first plate 310, the guide plate 420 may include a first fastening portion 425a and a second fastening portion 425b coupled to the second bracket 227. The second plate 320 may be a portion of the guide assembly 400 configured to be in contact with the first plate 310. However, embodiments of the present disclosure are not limited thereto.

For example, the second plate 320 may be disposed under a third display portion (e.g., the third display portion 233 of FIG. 2A) of the display 230 together with the first plate 310 in an unfolded state of the electronic device 101. For example, the first display portion 231 may be disposed above the first bracket 215. The second display portion 232 may be disposed above the second bracket 227. The third display portion 233 may extend from the first display portion 231 to the second display portion 232. The third display portion 233 may be at least partially disposed above the hinge structure 250. The third display portion 233 may be configured to be bent by the hinge structure 250 in a folded state of the electronic device 101. The first plate 310 and the second plate 320 of the guide assembly 400, respectively coupled to the hinge plates 252 and 253 of the hinge structure 250, may be disposed (e.g. fully or partially disposed) under the third display portion 233. For example, the plates 310 and 320 may overlap the third portion 233 of the display 230 when the display 230 is viewed from above (e.g., when viewed from a +z direction), but embodiments of the present disclosure are not limited thereto.

The guide assembly 400 may include a fastening member 430 (or coupling member 430) that couples the second plate 320 and/or the elastic member 410 to the guide plate 420. For example, the fastening member 430 may be in contact with the elastic member 410, the guide plate 420, and the second plate 320. For example, the fastening member 430 may include a first fastening member 431 that is coupled to the first elastic plate 411 and the guide plate 420, and that may be disposed adjacent to the first end portion 325a of the second plate 320. The fastening member 430 may include a second fastening member 432 that is coupled with the second elastic plate 412 and the guide plate 420, and that may be disposed adjacent to the second end portion 325b of the second plate 320. However, embodiments of the present disclosure are not limited thereto, and the guide assembly 400 may include various fastening structures that fasten the second plate 320 and/or the elastic member 410 to the guide plate 420 such that the second plate 320 and/or the elastic member 410 are not separated from the guide plate 420.

An area of the first surface 310a of the first plate 310 may correspond to an area of the second surface 320a of the second plate 320, e.g. such that the first surface 310a of the first plate 310 and the second surface 320a of the second plate 320 overlap in the unfolded state of the electronic device 101. For example, the area of the first surface 310a of the first plate 310 and the second surface 320a of the second plate 320 may be substantially the same as each other (e.g. in terms of surface area). For example, the first surface 310a of the first plate 310 may be in contact with the second surface 320a of the second plate 320 to overlap with each other, in an unfolded state of the electronic device 101. The first surface 310a and the second surface 320a may face each other to be in an aligned contact with each other in the unfolded state. However, embodiments of the present disclosure are not limited thereto.

The first plate 310 and the second plate 320 may have elasticity. For example, each of the plates 310 and 320 may be formed at least partially from a material (e.g., rubber) that is elastic. For example, the first surface 310a of the first plate 310 may be compressed by pressure exerted from the second surface 320a of the second plate 320. The second surface 320a may be compressed by a pressure exerted from the first surface 310a. Since each of the plates 310 and 320 has elasticity, the electronic device 101 may decrease damage to the plates 310 and 320 due to friction between the plates 310 and 320 while the electronic device 101 changes from a folded state to an unfolded state.

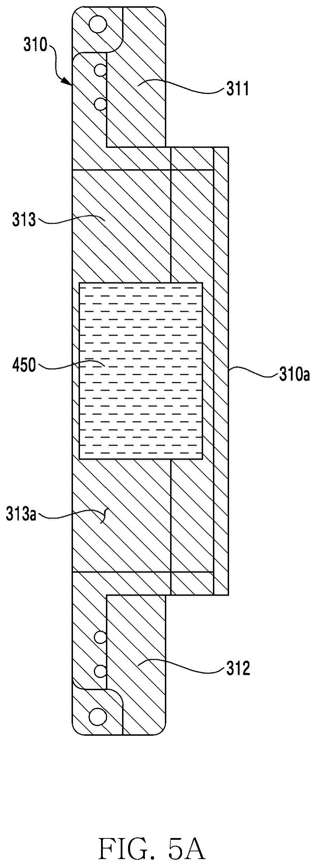

The electronic device 101 may include at least one heat conduction member for increasing heat conductivity of a heat conduction path (p) formed in an unfolded state of the electronic device 101 by the plates 310 and 320. The at least one heat conduction member may be attached to at least one of the first plate 310 and the guide assembly 400. For example, the electronic device 101 may include a first heat conduction member 450 (or first heat transfer region/portion 450) attached on the first plate 310 to be separated from the second plate 320. For example, the first heat conduction member 450 may be attached to an upper surface (e.g., an upper surface 313a of FIG. 5A) of the third portion 313 configured to be in contact with the second plate 320 among the portions 311, 312, and 313 of the first plate 310. The first heat conduction member 450 may, for example, be formed from graphite, but embodiments of the present disclosure are not limited thereto.

A structure for increasing the heat conductivity between the first plate 310 and the second plate 320 and a structure of an exemplary guide assembly 400 for an aligned contact between the first plate 310 and the second plate 320 will be described through an exemplary illustration of FIG. 5A and below.

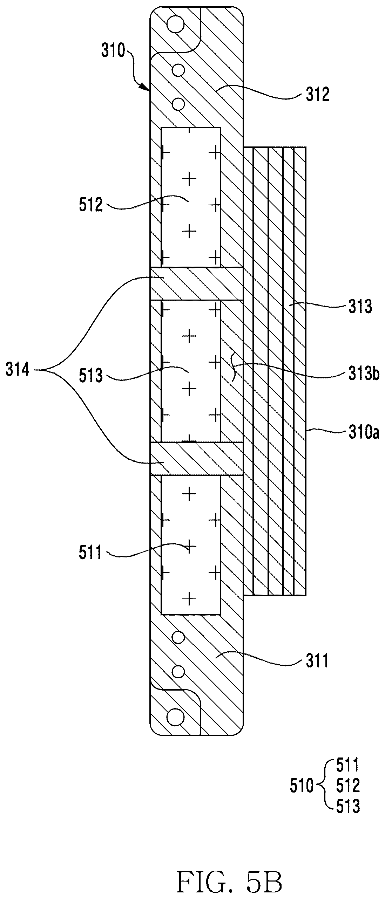

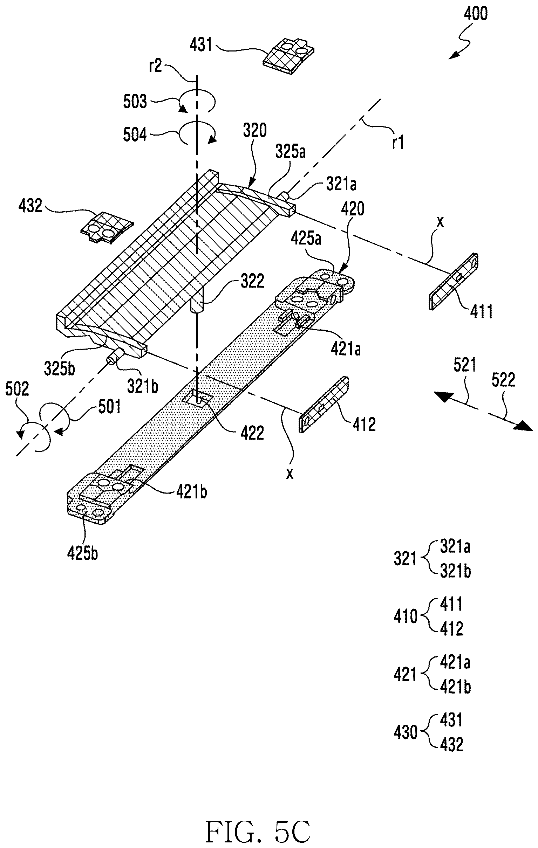

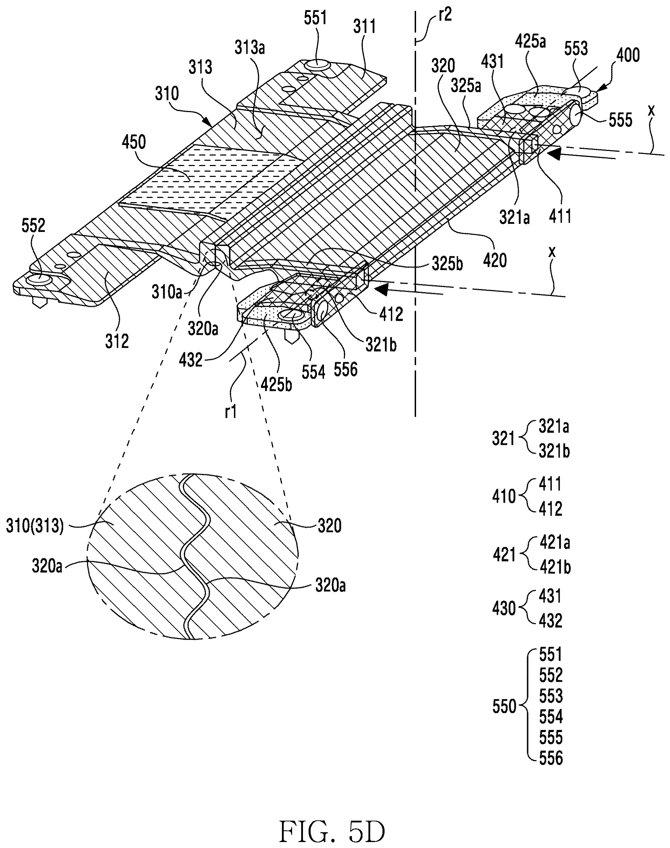

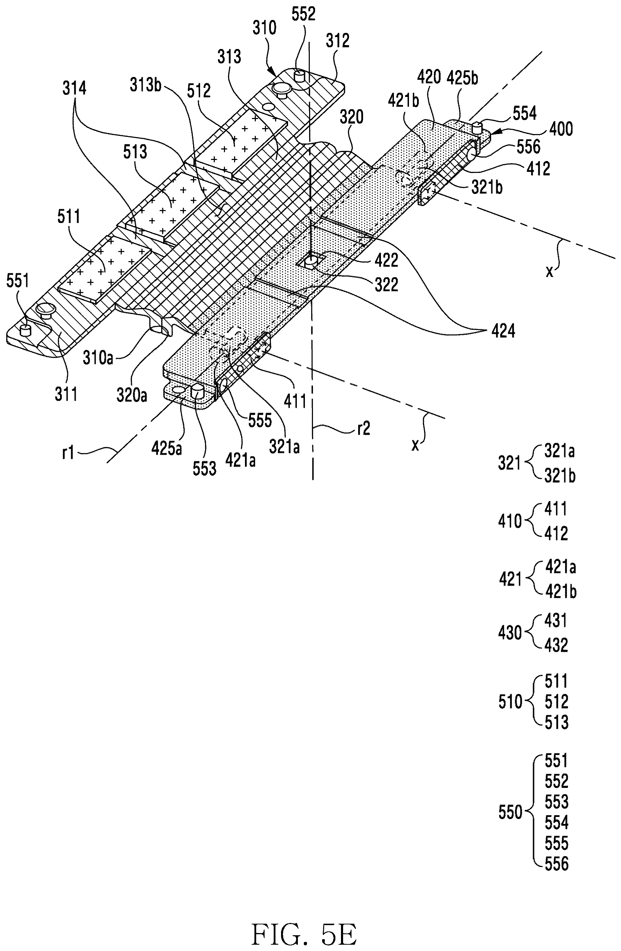

FIG. 5A is a top plan view of a first plate of an exemplary electronic device. FIG. 5B is a bottom view of a first plate of an exemplary electronic device. FIG. 5C is an exploded perspective view of a guide assembly of an exemplary electronic device. FIGS. 5D and 5E are perspective views of a first plate and a guide assembly of an exemplary electronic device in contact with each other. The electronic device of FIGS. 5A, 5B, 5C, 5D, and 5E may be that of FIG. 4.

Referring to FIGS. 5A, 5B, 5C, 5D, and 5E, an electronic device 101 may include a housing 200 including a first housing part 210 including a first plate 310 and a second housing part 220 including a guide assembly 400 including a second plate 320 and an elastic member 410. The electronic device 101 may include an electronic component (e.g., the processor 120 of FIG. 1 and the electronic component 301 of FIG. 3A) disposed in the housing 200. The electronic device 101 may include a hinge structure 250 rotatably coupling the first housing part 210 and the second housing part 220. The first plate 310 may be configured to be in contact with the second plate 320 in an unfolded state of the electronic device 101 such that the first plate 310 and the second plate 320 form a heat conduction path (e.g., the heat conduction path (p) of FIG. 3B) between the first housing part 210 and the second housing part 220 for heat generated from the electronic component 301. The elastic member 410 may provide a repulsion force to the second plate 320 toward the first plate 310 with respect to a force exerted to the first plate 310 from the second plate 320 in the unfolded state of the electronic device 101 such that the second plate 320 is closely contacted with the first plate 310. However, an embodiment supported by the present disclosure is not limited thereto, and the electronic device 101 exemplarily illustrated and described in FIGS. 5A to 5E may include structures and/or configurations of the electronic device 101 exemplarily illustrated and described in FIGS. 2A to 4. Additionally, hereinafter, a redundant description of structures and/or configurations having the same reference numeral as the structures and/or the configurations described in FIGS. 2A to 4 may be omitted.

Referring to FIGS. 5A and 5B, an exemplary first plate 310 is illustrated. A first portion 311 and a second portion 312 corresponding to end portions of the first plate 310 may be coupled to a first bracket (e.g., the first bracket 215 of FIG. 2C) of the first housing part 210, respectively, through a fastener (e.g., a fastener 550 of FIG. 5D). A third portion 313 may correspond to a central portion of the first plate 310. The third portion 313, or at least a part thereof, may be configured to be in contact with the second plate 320 by protruding from the first portion 311 and the second portion 312. For example, in order to increase heat conductivity between the first plate 310 and the second plate 320, at least one heat conduction member may be attached to the third portion 313 of the first plate 310 contacting the second plate 320.

For example, a first heat conduction member 450 may be attached to an upper surface 313a of the third portion 313. For example, a second heat conduction member 510 (or at least one second heat conduction member 510) may be attached to a lower surface 313b of the third portion 313, which is opposite to the upper surface 313a. For example, the second heat conduction member 510 may include a first heat conduction portion 511 attached or disposed partially under the first portion 311, a second heat conduction portion 512 attached or disposed partially under the second portion 312, and a third heat conduction portion 513 disposed between the first heat conduction portion 511 and the second heat conduction portion 512 and attached to or disposed on the lower surface 313b of the third portion 313. However, embodiments of the present disclosure are not limited thereto, and the electronic device 101 may include various heat conduction members attached to the first plate 310.

The first plate 310 may include a first guide rail 314 that slidably couples the first plate 310 to the first hinge plate 252. For example, the first guide rail 314 may be formed on the lower surface 313b of the third portion 313 of the first plate 310 configured to be in contact with the second plate 320. Through the first guide rail 314, the first plate 310 may slide toward the second plate 320 while the electronic device 101 changes from a folded state to an unfolded state. However, embodiments of the present disclosure are not limited thereto. The first plate 310 may be rotated in conjunction with the hinge structure 250 by including portions 311 and 312 fastened to the first bracket 215 and a third portion 313 slidably coupled to the first hinge plate 252.

Referring to FIG. 5C, an exemplary guide assembly 400 is illustrated. Referring to FIGS. 5D and 5E, an exemplary first plate 310 and a guide assembly 400 for forming a heat conduction path (p) in an unfolded state of the electronic device 101 are illustrated.

The second plate 320 may include a shaft 321 (or rod 321, protrusion 321 etc.) inserted into a shaft hole 421 (or hole 421, opening 421 etc.) of a guide plate 420 and providing a first rotational axis r1 of the second plate 320 with respect to the guide plate 420. For example, the shaft 321 may be formed at end portions 325a and 325b of the second plate 320. The shaft 321 may include a first shaft 321a protruding from the first end portion 325a of the second plate 320 and a second shaft 321b protruding from the second end portion 325b of the second plate 320. For example, directions in which the shafts 321a and 321b protrude may be opposite to each other. However, an embodiment supported by the present disclosure is not limited thereto. For example, the shaft hole 421 may accommodate the shaft 321 of the second plate 320. The shaft hole 421 may include a first shaft hole 421a that accommodates the first shaft 321a and a second shaft hole 421b that accommodates the second shaft 321b.

For example, the shafts 321a and 321b may be rotatably coupled to the shaft holes 421a and 421b, and may be aligned in a straight line to provide a first rotational axis r1 to the second plate 320. For example, the second plate 320 may be coupled to the guide plate 420 to be rotatable in a rotation direction 501 and a rotation direction 502 opposite to the rotation direction 501 based on the first rotational axis r1 with respect to the guide plate 420 through the shaft 321.

The second plate 320 may include a protrusion 322 (or rod 322) inserted into a guide hole 422 (or opening 422, hole 422 etc.) of the guide plate 420 and providing a second rotational axis r2 of the second plate 320 with respect to the guide plate 420. For example, the protrusion 322 may be formed in a center portion of the second plate 320. For example, the protrusion 322 may be positioned on a center of gravity of the second plate 320, but an embodiment is not limited thereto. For example, the guide hole 422 may be penetrated by the protrusion 322 of the second plate 320.

For example, the protrusion 322 may provide the second plate 320 with the second rotational axis r2 different from (e.g. orthogonal to) the first rotational axis r1 by being rotatably coupled to the guide hole 422. For example, the second plate 320 may be coupled to the guide plate 420 to be rotatable in a rotation direction 503 and a rotation direction 504 opposite to the rotation direction 503 based on the second rotational axis r2 with respect to the guide plate 420 through the protrusion 322.

The elastic member 410 may be coupled to the guide plate 420 to provide a translational axis (x) to the second plate 320 with respect to the guide plate 420 by pressing or exerting a force on the second plate 320. For example, the second plate 320 may be coupled to the guide plate 420 to be translatable (or slidable, movable etc.) based on the translational axis (x). For example, a size of the shaft hole 421 may be larger than a size of the shaft 321 accommodated in the shaft hole 421 to provide the translational axis (x). For example, the shaft hole 421 is formed such that the shaft 321 is movable within the shaft hole 421 in a direction 521 and a direction 522. For example, a size of the guide hole 422 may be larger than a size of the protrusion 322 penetrating the guide hole 422 to provide the translational axis (x). For example, the guide hole 422 is formed such that the protrusion 322 is movable within the guide hole 422 in a direction 521 and a direction 522. For example, since the second plate 320 is rotatable with respect to the first rotational axis r1 and the second rotational axis r2 with respect to the guide plate 420, the second plate 320 may be movable (or slidable) in a direction 521 corresponding to the translational axis (x) and a direction 522 opposite to the direction 521.

For example, while the electronic device 101 changes from a folded state to an unfolded state, the second plate 320 may rotate in the direction 503 with respect to the guide plate 420 based on the second rotational axis r2. As the second plate 320 is rotated in the direction 503, the first end portion 325a of the second plate 320 may contact the first plate 310 before the second end portion 425b of the second plate 320. The second end portion 325b may translate (e.g. may move or be moved) to contact the first plate 310 by being pressed in the direction 521 parallel to the translational axis (x) by a second elastic plate 412, after the first end portion 325a is in contact with the first plate 310. For example, while the electronic device 101 changes from a folded state to an unfolded state, the second plate 320 may rotate in the direction 504 with respect to the guide plate 420 based on the second rotational axis r2. As the second plate 320 is rotated in the direction 504, the second end portion 325b of the second plate 320 may contact the first plate 310 before the first end portion 325a of the second plate 320. The first end portion 325a may translate (e.g. may move or be moved) to contact the first plate 310 by being pressed in the direction 521 parallel to the translational axis (x) by a first elastic plate 411, after the second end portion 325b is in contact with the first plate 310. However, embodiments of the present disclosure are not limited thereto, and the elastic member 410 may be configured to enable the second plate 320 to be in close contact with the first plate 310 by providing a repulsion force with respect to a force exerted to in the direction 522 from the second plate 320, while the electronic device 101 changes from a folded state to an unfolded state.

The translational axis (x) provided from the elastic member 410, the first rotational axis r1 provided from the shaft 321, and the second rotational axis r2 provided from the protrusion 322 may be perpendicular to each other. However, embodiments of the present disclosure are not limited thereto. As the second plate 320 is configured to have a plurality of degrees of freedom with respect to the guide plate 420, the guide assembly 400 may re-align or re-adjust a position of the second plate 320 such that the first plate 310 is in aligned contact with the second plate 320 while the electronic device 101 changes from a folded state to an unfolded state.

The electronic device 101 may include the first plate 310 and the fastener 550 for fastening the guide assembly 400. For example, the fastener 550 (or attached 550, coupler 550 etc.) may include fasteners 551 and 552 that fasten the portions 311 and 312 of the first plate 310 to the first bracket 215 of the first housing part 210. For example, the fastener 550 may include fasteners 553 and 554 penetrating fastening portions 425a and 425b of the guide plate 420 to fasten the guide plate 420 to the second bracket 227 of the second housing part 220. For example, the fastener 550 may include fasteners 555 and 556 that fasten the elastic member 410 to the guide plate 420. For example, an end of the first elastic plate 411 may be fastened to the guide plate 420 through the fastener 555. Another end of the first elastic plate 411 may be in contact with or coupled to the first end 325a of the second plate 320 to provide an elastic force to the second plate 320. For example, an end of the second elastic plate 412 may be fastened to the guide plate 420 through the fastener 556. Another end of the second elastic plate 412 may be in contact with or coupled to the second end portion 325b of the second plate 320 to provide the elastic force to the second plate 320. However, embodiments of the present disclosure are not limited thereto.

Similar to the first guide rail 314 of the first plate 310, the guide plate 420 of the guide assembly 400 may include a second guide rail that slidably couples the guide assembly 400 to the second hinge plate 253. For example, the fastening portions 425a and 425b of the guide plate 420 may be fastened to the second bracket 227 through the fasteners 553 and 554. The guide plate 420 may be rotated linked with the hinge structure 250 by being slidably coupled to the second hinge plate 253 through the second guide rail. However, embodiments of the present disclosure are not limited thereto.

A first surface 310a and a second surface 320a configured to be in contact with each other in an unfolded state of the electronic device 101 may have a shape (e.g. may each have a shape) for increasing a contact area. For example, referring to FIG. 5D, the first surface 310a of the first plate 310 and the second surface 320a of the second plate 320 may have a shape that corresponds to each other and is curved (or a zig-zag shape). For example, the first surface 310a and the second surface 320a have undulating or non-linear shapes formed to fit one another to provide flush contact between the first surface 310a and the second surface 320a. In various examples, the first surface of the first heat-conductive plate has a shape corresponding to a shape of the second surface of the second heat-conductive plate such that a region of the first surface of the first heat-conductive plate is partially surrounded by a region of the second surface of the second heat-conductive plate when the electronic device 101 is in the unfolded state. However, embodiments of the present disclosure are not limited thereto, and the first surface 310a and the second surface 320a may have various shapes for increasing the contact area.

According to the above-described embodiment, the guide assembly 400 of the electronic device 101 may guide a position of the second plate 320 for forming the heat conduction path (p) while the electronic device 101 changes from a folded state to an unfolded state by including the second plate 320 coupled to have a degree of freedom with respect to the guide plate 420. The guide assembly 400 may provide an aligned contact between the first plate 310 and the second plate 320 for forming the heat conduction path (p) by including the elastic member 410 pressing the second plate 320 that is shiftable with respect to the guide plate 420 toward the first plate 310.

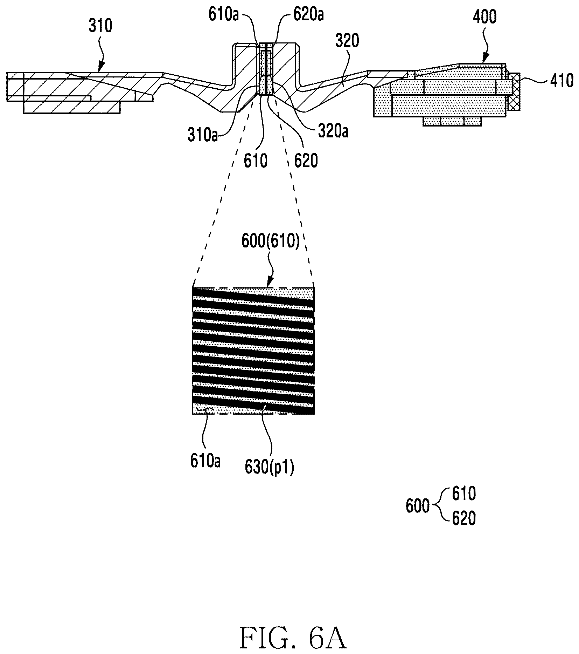

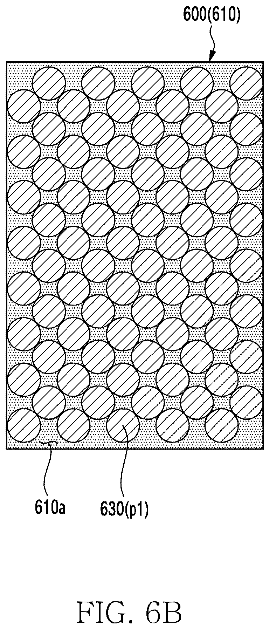

FIG. 6A is a side view of a first plate and a guide assembly of an exemplary electronic device. FIG. 6B illustrates a portion of a second heat conduction member of an exemplary electronic device.

Referring to FIGS. 6A and 6B, an electronic device 101 may include a housing 200 including a first housing part 210 including a first plate 310, and a second housing part 220 including a guide assembly 400 including a second plate 320 and an elastic member 410. The electronic device 101 may include an electronic component (e.g., the processor 120 of FIG. 1 and the electronic component 301 of FIG. 3A) disposed in the housing 200. The electronic device 101 may include a hinge structure 250 rotatably coupling the first housing part 210 and the second housing part 220. The first plate 310 may be configured to be in contact with the second plate 320 in an unfolded state of the electronic device 101 such that the first plate 310 and the second plate 320 form a heat conduction path (e.g., the heat conduction path (p) of FIG. 3B) between the first housing part 210 and the second housing part 220 for heat generated from the electronic component 301. The elastic member 410 may provide a force (e.g. a repulsion force) to the second plate 320 toward the first plate 310 with respect to a force exerted to the first plate 310 from the second plate 320 in the unfolded state of the electronic device 101 such that the second plate 320 is closely contacted with the first plate 310. However, an embodiment supported by the present disclosure is not limited thereto, and the electronic device 101 exemplarily illustrated and described in FIGS. 6A and 6B may include structures and/or configurations of the electronic device 101 exemplarily illustrated and described in FIGS. 2A to 5E. Additionally, hereinafter, a redundant description of structures and/or configurations having the same reference numeral as the structures and/or the configurations described in FIGS. 2A to 5E may be omitted.

The electronic device 101 may include a third heat conduction member 600 interposed between the first plate 310 and the second plate 320 in an unfolded state of the electronic device 101. The third heat conduction member 600 may include a first deformable portion 610 attached to a first surface 310a of the first plate 310 and a second deformable portion 620 attached to a second surface 320a of the second plate 320 and in direct contact with the first deformable portion 610 in the unfolded state of the electronic device 101. The first deformable portion 610 and the second deformable portion 620 may be configured to be compressed by each other to provide close contact between the first deformable portion 610 and the second deformable portion 620 in the unfolded state.

For example, the third heat conduction member 600 may be formed from a material (e.g., rubber) that is deformable or elastic. For example, the first deformable portion 610 may be attached to the first surface 310a of the first plate 310 facing the second plate 320 in an unfolded state of the electronic device 101. The second deformable portion 620 may be attached to the second surface 320a of the second plate 320 facing the first plate 310 in the unfolded state. The deformable portions 610 and 620 may be compressed by contacting each other in the unfolded state (e.g. with a force being applied in the unfolded state to cause such compression). The deformable portions 610 and 620 may decrease damage to the plates 310 and 320 due to friction between the plates 310 and 320 by being configured to be compressed in the unfolded state. For example, a fourth surface 620a of the second deformable portion 620 may be configured to align to be contacted with a third surface 610a of the first deformable portion 610 by the elastic member 410 of the guide assembly 400. However, embodiments of the present disclosure are not limited thereto.

The third heat conduction member 600 may include a metal material 630. The metal material 630 may form at least a portion of the third surface 610a of the first deformable part 610 and at least a portion of the fourth surface 620a of the second deformable portion 620 configured to be in direct contact with the third surface 610a of the first deformable portion 610 in an unfolded state of the electronic device 101.

For example, when referring to FIG. 6A, the third surface 610a of the first deformable portion 610 may include a metal material 630 forming a pattern p1 having a diagonal shape. The fourth surface 620a of the second deformable portion 620 configured to be in contact with the third surface 610a may include a metal material 630 forming the pattern p1 substantially the same as the third surface 610a. For example, referring to FIG. 6B, the third surface 610a of the first deformable portion 610 may include a metal material 630 forming a pattern p2 having a circular shape. The fourth surface 620a of the second deformable portion 620 configured to be in contact with the third surface 610a may include a metal material 630 forming the pattern p2 substantially the same as the third surface 610a. For example, the metal material 630 forming at least a portion of the third surface 610a may be formed to contact the metal material 630 forming at least a portion of the fourth surface 620a. However, embodiments of the present disclosure are not limited thereto. The third heat conduction member 600 may improve heat conductivity of a heat conduction path (p) formed by the plates 310 and 320 in the unfolded state of the electronic device 101 by including the metal material 630 in the deformable portions 610 and 620. In various examples, the metal material 630 is more generally a material with improved heat conductivity compared to the deformable or elastic material forming another portion of the third heat conduction member 600.

The technical problems to be achieved in this document are not limited to those described above, and other technical problems not mentioned herein will be clearly understood by those having ordinary knowledge in the art to which the present disclosure belongs.

According to the above, a foldable electronic device (e.g., the electronic device 101 of FIG. 1) may comprise a housing including a first housing part including a first heat-conductive plate and a second housing part including a second heat-conducive plate and an elastic member, an electronic component disposed in the housing, and a hinge assembly rotatably coupling the first housing part and the second housing part. The first heat-conductive plate may be configured to be in contact with the second heat-conductive plate in an unfolded state of the foldable electronic device such that the first and second heat-conductive plates form a heat conduction path between the first and second housing parts for heat generated from the electronic component. The elastic member may provide a repulsion force to the second heat-conductive plate toward the first heat-conductive plate in the unfolded state of the foldable electronic device such that the second heat-conductive plate is closely contacted with the first heat-conductive plate.

According to the above, a foldable electronic device (e.g., the electronic device 101 of FIG. 1) may comprise a housing (e.g., the housing 200 of FIG. 2A) including a first housing part (e.g., the first housing part 210 of FIG. 2A) including a first heat-conductive plate (e.g., the first plate 310 of FIG. 3A) and a second housing part (e.g., the second housing part 220 of FIG. 2A) including a guide assembly (e.g., the guide assembly 400 of FIG. 4) including a second heat-conducive plate (e.g., the second plate 320 of FIG. 3A) and an elastic member (e.g., the elastic member 410 of FIG. 4), an electronic component (e.g., the processor 120 of FIG. 1 and the electronic component 301 of FIG. 3A) disposed in the housing, and a hinge assembly (e.g., the hinge structure 250 of FIG. 2B) rotatably coupling the first housing part and the second housing part. The first heat-conductive plate may be configured to contact the second heat-conductive plate in an unfolded state of the foldable electronic device such that the first and second heat-conductive plates form a heat conduction path (e.g., the heat conduction path (p) of FIG. 3B) between the first and second housing parts for heat generated from the electronic component. The elastic member may provide a repulsion force to the second heat-conductive plate toward the first heat-conductive plate with respect to a force exerted to the first heat-conductive plate from the second heat-conductive plate in the unfolded state of the foldable electronic device such that the second heat-conductive plate is closely contacted with the first heat-conductive plate.

For example, the hinge assembly may include a first hinge plate (e.g., the first hinge plate 252 of FIG. 2C) to which the first heat-conductive plate is slidably coupled, and a second hinge plate (e.g., the second hinge plate 253 of FIG. 2C) to which the second heat-conductive plate is slidably coupled. While the foldable electronic device is changing from a folded state to the unfolded state, the elastic member may provide aligned contacting between a first surface (e.g., the first surface 310a of FIG. 3A) of the first heat-conductive plate sliding with respect to the first hinge plate toward the second heat-conductive plate and a second surface (e.g., the second surface 310b of FIG. 3A) of the second heat-conductive plate sliding with respect to the second hinge plate toward the first heat-conductive plate.

For example, an area of the first surface of the first heat-conductive plate may correspond to an area of the second surface of the second heat-conductive plate such that the first surface of the first heat-conductive plate overlaps the second surface of the second heat-conductive plate in the unfolded state of the foldable electronic device.

For example, the guide assembly may further include a guide plate (e.g., the guide plate 420 of FIG. 4), to which the second heat-conductive plate is movably coupled. The elastic member may be coupled to the guide plate to provide a translational axis (e.g., the translational axis (x) of FIG. 5C) to the second heat-conductive plate with respect to the guide plate by pressuring the second heat-conductive plate.

For example, the second heat-conductive plate may include a shaft (e.g., the shaft 321 of FIG. 5C), inserted in a shaft hole (e.g., the shaft hole 421 of FIG. 5C) of the guide plate, providing a first rotational axis (e.g., the first rotational axis r1 of FIG. 5C) of the second heat-conductive plate with respect to the guide plate.

For example, the second heat-conductive plate may further include a protrusion (e.g., the protrusion 422 of FIG. 5C) inserted in a guide hole (e.g., the guide hole 422 of FIG. 5C) of the guide plate, providing a second rotational axis (e.g., the second rotational axis r2 of FIG. 5C), different from the first rotational axis, with respect to the guide plate.

For example, the translational axis, the first rotational axis, and the second rotational axis may be perpendicular to each other.

For example, the elastic member may include a first elastic plate (e.g., the first elastic plate 411 of FIG. 4) contacting a longitudinal end portion (e.g., the first end portion 325a of FIG. 4) of the second heat-conductive plate, and a second elastic plate (e.g., the second elastic plate 412 of FIG. 4), spaced apart from the first elastic plate, contacting another longitudinal end portion (e.g., the second end portion 325b of FIG. 4) of the second heat-conductive plate.

For example, the foldable electronic device may further include a heat conduction member attached to at least one of the first heat-conductive plate and the guide assembly.

For example, the heat conduction member may include a first heat conduction member (e.g., the first heat conduction member 450 of FIG. 4), attached on the first heat-conductive plate to be separated from the second heat-conductive plate, formed from graphite.

For example, the heat conduction member may include a second heat conduction member (e.g., the third heat conduction member 600 of FIG. 6A), configured to be interposed between the first heat-conductive plate and the second heat-conductive plate in the unfolded state of the foldable electronic device. The second heat conduction member may include a first deformable portion (e.g., the first deformable portion 610 of FIG. 6A), attached to a first surface of the first heat-conductive plate, and a second deformable portion (e.g., the second deformable portion 620 of FIG. 6A), attached to a second surface of the second heat-conductive plate, configured to be in directly contact with the first surface in the unfolded state of the foldable electronic device. The first and second deformable portions may be configured to be compressed by each other to provide close contact between the first and second deformable portions in the unfolded state of the foldable electronic device.

For example, the second heat conduction member may comprise a metal material (e.g., the metal material 630 of FIG. 6A). The metal material may form at least a portion of a third surface (e.g., the third surface 610a of FIG. 6A) of the first deformable portion and at least a portion of a fourth surface (e.g., the fourth surface 620a of FIG. 6A) of the second deformable portion configured to be in directly contact with the third surface of the first deformable portion in the unfolded state of the foldable electronic device.

For example, the foldable electronic device may further comprise a flexible display including a first display portion (e.g., the first display portion 231 of FIG. 2A) coupled to the first housing part, a second display portion (e.g., the second display portion 232 of FIG. 2A) coupled to the second housing part, and a third display portion (e.g., the third display portion 233 of FIG. 2A), extending from the first display portion to the second display portion, configured to be bent by the hinge assembly in a folded state of the foldable electronic device.

For example, the first housing part may further include a first bracket (e.g., the first bracket 215 of FIG. 2C), supporting the first display portion of the flexible display, coupled to the first heat-conductive plate. The second housing part may further include a second bracket (e.g., the second bracket 227 of FIG. 2C), supporting the second display portion of the flexible display, coupled to the guide assembly. The second heat-conductive plate may be movable with respect to the second bracket and may be disposed under the third display portion together with the first heat-conductive plate in the unfolded state of the foldable electronic device.

For example, the first and second heat-conductive plates may have elasticity.

According to the above, a foldable electronic device may comprise a housing including a first housing part including a first heat-conductive plate and a second housing part, a guide assembly including a guide plate coupled to the second housing part, a second heat-conducive plate movably coupled to the guide plate, and an elastic member, coupled to the guide plate to be in contact with the second heat-conductive plate, an electronic component disposed in the housing, and a hinge assembly rotatably coupling the first housing part and the second housing part through the first heat-conductive plate and the guide assembly. The first heat-conductive plate of the second housing part may be configured to contact with the second heat-conductive plate of the first housing part in an unfolded state of the foldable electronic device such that the first and second heat-conductive plates form a heat conduction path between the first and second housing parts for heat generated from the electronic component. The elastic member may provide a repulsion force to the second heat-conductive plate toward the first heat-conductive plate with respect to a force exerted to the first heat-conductive plate from the second heat-conductive plate in the unfolded state of the foldable electronic device such that the second heat-conductive plate is closely contacted with the first heat-conductive plate.

For example, the hinge assembly may include a first hinge plate to which the first heat-conductive plate is slidably coupled, and a second hinge plate to which the second heat-conductive plate is slidably coupled. While the foldable electronic device is changing from a folded state to the unfolded state, the elastic member may provide aligned contact between a first surface of the first heat-conductive plate sliding with respect to the first hinge plate toward the second heat-conductive plate and a second surface of the second heat-conductive plate sliding with respect to the second hinge plate toward the first heat-conductive plate.

For example, the elastic member may provide a translational axis to the second heat-conductive plate with respect to the guide plate by pressuring the second heat-conductive plate. The second heat-conductive plate may include a shaft, inserted in a shaft hole of the guide plate, providing a first rotational axis of the second heat-conductive plate with respect to the guide plate, and a protrusion inserted in a guide hole of the guide plate, providing a second rotational axis different from the first rotational axis, with respect to the guide plate.

For example, the translational axis, the first rotational axis, and the second rotational axis may be perpendicular to each other.

For example, the foldable electronic device may further comprise a heat conduction member attached to at least one of the first heat-conductive plate and the guide assembly.

According to a first example of the present disclosure, there is provided a foldable electronic device comprising: a housing including: a first housing part including a first heat-conductive plate; a second housing part including a second heat-conductive plate and an elastic member, an electronic component disposed in the housing; and a hinge assembly rotatably coupling the first housing part and the second housing part, wherein the first heat-conductive plate is configured to be in contact with the second heat-conductive plate in an unfolded state of the foldable electronic device such that the first and second conductive plates form a heat conduction path between the first and second housing parts for heat generated from the electronic component, and wherein the elastic member is configured to provide a force to the second heat-conductive plate toward the first heat-conductive plate in the unfolded state of the foldable electronic device such that the second heat-conductive plate is forced towards and/or aligned with the first heat-conductive plate.

According to a second example, there is provided the foldable electronic device of the first example, wherein the second heat-conductive plate and the elastic member are included in a guide assembly included in the second housing part; wherein the hinge assembly includes: a first hinge plate to which the first heat-conductive plate is slidably coupled; and a second hinge plate to which the guide assembly is slidably coupled, wherein, while the foldable electronic device is changing from a folded state to the unfolded state, the elastic member aligns a first surface of the first heat-conductive plate sliding with respect to the first hinge plate toward the second heat-conductive plate and a second surface of the second heat-conductive plate of the guide assembly sliding with respect to the second hinge plate toward the first heat-conductive plate.

According to a third example, there is provided the foldable electronic device of the second example, wherein an area of the first surface of the first heat-conductive plate corresponds to an area of the second surface of the second heat-conductive plate such that the first surface of the first heat-conductive plate overlaps the second surface of the second heat-conductive plate in the unfolded state of the foldable electronic device.

According to a fourth example, there is provided the foldable electronic device of the second example or the third example, wherein the first surface of the first heat-conductive plate has a shape corresponding to a shape of the second surface of the second heat-conductive member such that a region of the first surface of the first heat-conductive plate is partially surrounded by a region of the second surface of the second heat-conductive plate in the unfolded state of the foldable electronic device.

According to a fifth example, there is provided the foldable electronic device of the first example, wherein the second heat-conductive plate and the elastic member are included in a guide assembly included in the second housing part; wherein the guide assembly further includes a guide plate, to which the second heat-conductive plate is movably coupled, and wherein the elastic member is coupled to the guide plate to provide a translational axis along which the second heat-conductive plate is movable with respect to the guide plate by providing the force to the second heat-conductive plate.

According to a sixth example, there is provided the foldable electronic device of the fifth example, wherein the second heat-conductive plate includes a shaft, inserted in a shaft hole of the guide plate, and configured to provide a first rotational axis of the second heat-conductive plate with respect to the guide plate.

According to a seventh example, there is provided the foldable electronic device of the sixth example, wherein the second heat-conductive plate further includes a protrusion inserted in a guide hole of the guide plate and configured to provide a second rotational axis, different from the first rotational axis of the second heat-conductive plate, with respect to the guide plate.

According to a eighth example, there is provided the foldable electronic device of the seventh example, wherein the first rotational axis, the second rotational axis, and the translational axis are perpendicular to each other.

According to a ninth example, there is provided the foldable electronic device of any one of the first example to the eighth example, wherein the elastic member includes: a first elastic plate contacting a first longitudinal end portion of the second heat-conductive plate; and a second elastic plate contacting a second longitudinal end portion of the second heat-conductive plate.

According to a tenth example, there is provided the foldable electronic device of any one of the first example to the ninth example, further comprising a heat conduction member attached to at least one of the first heat-conductive plate and the guide assembly.

According to a eleventh example, there is provided the foldable electronic device of the tenth example, wherein the heat conduction member includes a first heat conduction member, attached on the first heat-conductive plate to be separated from the second heat-conductive plate and formed from graphite.

According to a twelfth example, there is provided the foldable electronic device of the tenth example or the eleventh example, wherein the heat conduction member includes a second heat conduction member, configured to be interposed between the first heat-conductive plate and the second heat-conductive plate in the unfolded state of the foldable electronic device, and including: a first deformable portion attached to the first heat-conductive plate; and a second deformable portion attached to the second heat-conductive plate and configured to be in direct contact with the first deformable portion in the unfolded state of the foldable electronic device, and wherein the first and second deformable portions are configured to be compressed by each other in the unfolded state of the foldable electronic device.

According to a thirteenth example, there is provided the foldable electronic device of the twelfth example, wherein the second heat conduction member comprises a metal material, and wherein the metal material is configured to form at least a portion of a surface of the first deformable portion and at least a portion of a surface of the second deformable portion configured to be in direct contact with the surface of the first deformable portion in the unfolded state of the foldable electronic device.

According to a fourteenth example, there is provided the foldable electronic device of any one of the first example to the thirteenth example, further comprising: a flexible display including a first display portion coupled to the first housing part, a second display portion coupled to the second housing part, and a third display portion, extending from the first display portion to the second display portion, configured to be bent by the hinge assembly in a folded state of the foldable electronic device, wherein the first housing part further includes a first bracket, supporting the first display portion of the flexible display, coupled to the first heat-conductive plate, wherein the second housing part further includes a second bracket, supporting the second display portion of the flexible display, coupled to the second heat-conductive plate, and wherein the second heat-conductive plate is movable with respect to the second bracket and disposed under the third display portion together with the first heat-conductive plate in the unfolded state of the foldable electronic device.

According to a fifteenth example, there is provided the foldable electronic device of any one of the first example to the fourteenth example, wherein the first and second heat-conductive plates have elasticity.

Herein, the terms 'heat-conductive plate' and 'heat conduction member' are used, but it will be appreciated that these terms could be replaced by 'thermal-conductive plate' and 'thermal conduction member', respectively. Additionally, the term 'heat-conductive plate' could be replaced by heat-conducting plate, heat-conduction plate or the like.

In various embodiments, an electronic device may comprise a third housing part rotatably coupled, e.g. by another hinge assembly, to one of the first housing part or the second housing part, to provide a device having three housing parts that may form a stack when in a fully folded state (e.g. when the first housing part and the second housing part are folded together and the third housing part and the one or the first and second housing parts are folded together). Such an electronic device may have a Z-type form or a G-type form, depending on a shape of the device when fully folded. In such an electronic device, the other hinge assembly may be in accordance with any of the hinge assembly examples/embodiments described herein.

The effects that can be obtained from the present disclosure are not limited to those described above, and any other effects not mentioned herein will be clearly understood by those having ordinary knowledge in the art to which the present disclosure belongs.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A foldable electronic device comprising:
a housing including:
a first housing part including a first heat-conductive plate;
a second housing part including a second heat-conductive plate and an elastic member,
an electronic component disposed in the housing; and
a hinge assembly rotatably coupling the first housing part and the second housing part,
wherein the first heat-conductive plate is configured to be in contact with the second heat-conductive plate in an unfolded state of the foldable electronic device such that the first and second conductive plates form a heat conduction path between the first and second housing parts for heat generated from the electronic component, and
wherein the elastic member is configured to provide a force to the second heat-conductive plate toward the first heat-conductive plate in the unfolded state of the foldable electronic device such that the second heat-conductive plate is forced towards the first heat-conductive plate.

2. The foldable electronic device of claim 1,
wherein the second heat-conductive plate and the elastic member are included in a guide assembly included in the second housing part;
wherein the hinge assembly includes:
a first hinge plate to which the first heat-conductive plate is slidably coupled; and
a second hinge plate to which the guide assembly is slidably coupled,
wherein, while the foldable electronic device is changing from a folded state to the unfolded state, the elastic member aligns a first surface of the first heat-conductive plate sliding with respect to the first hinge plate toward the second heat-conductive plate and a second surface of the second heat-conductive plate of the guide assembly sliding with respect to the second hinge plate toward the first heat-conductive plate.

3. The foldable electronic device of claim 2,
wherein an area of the first surface of the first heat-conductive plate corresponds to an area of the second surface of the second heat-conductive plate such that the first surface of the first heat-conductive plate overlaps the second surface of the second heat-conductive plate in the unfolded state of the foldable electronic device.

4. The foldable electronic device of claim 2 or claim 3, wherein the first surface of the first heat-conductive plate has a shape corresponding to a shape of the second surface of the second heat-conductive plate such that a region of the first surface of the first heat-conductive plate is partially surrounded by a region of the second surface of the second heat-conductive plate in the unfolded state of the foldable electronic device.

5. The foldable electronic device of claim 1,
wherein the second heat-conductive plate and the elastic member are included in a guide assembly included in the second housing part;
wherein the guide assembly further includes a guide plate, to which the second heat-conductive plate is movably coupled, and
wherein the elastic member is coupled to the guide plate to provide a translational axis along which the second heat-conductive plate is movable with respect to the guide plate by providing the force to the second heat-conductive plate.

6. The foldable electronic device of claim 5,
wherein the second heat-conductive plate includes a shaft, inserted in a shaft hole of the guide plate, and configured to provide a first rotational axis of the second heat-conductive plate with respect to the guide plate.

7. The foldable electronic device of claim 6,
wherein the second heat-conductive plate further includes a protrusion inserted in a guide hole of the guide plate and configured to provide a second rotational axis, different from the first rotational axis of the second heat-conductive plate, with respect to the guide plate.

8. The foldable electronic device of claim 7,
wherein the first rotational axis, the second rotational axis, and the translational axis are perpendicular to each other.

9. The foldable electronic device of any one of the previous claims,
wherein the elastic member includes:
a first elastic plate contacting a first longitudinal end portion of the second heat-conductive plate; and
a second elastic plate contacting a second longitudinal end portion of the second heat-conductive plate.

10. The foldable electronic device of any one of the previous claims, further including:
a heat conduction member attached to at least one of the first heat-conductive plate and the guide assembly.

11. The foldable electronic device of claim 10,
wherein the heat conduction member includes a first heat conduction member, attached on the first heat-conductive plate to be separated from the second heat-conductive plate and formed from graphite.

12. The foldable electronic device of claim 10 or claim 11,
wherein the heat conduction member includes a second heat conduction member, configured to be interposed between the first heat-conductive plate and the second heat-conductive plate in the unfolded state of the foldable electronic device, and including:
a first deformable portion attached to the first heat-conductive plate; and
a second deformable portion attached to the second heat-conductive plate and configured to be in direct contact with the first deformable portion in the unfolded state of the foldable electronic device, and
wherein the first and second deformable portions are configured to be compressed by each other in the unfolded state of the foldable electronic device.

13. The foldable electronic device of claim 12,
wherein the second heat conduction member comprises a metal material, and
wherein the metal material is configured to form at least a portion of a surface of the first deformable portion and at least a portion of a surface of the second deformable portion configured to be in direct contact with the surface of the first deformable portion in the unfolded state of the foldable electronic device.

14. The foldable electronic device of any one of the previous claims, further comprising:
a flexible display including a first display portion coupled to the first housing part, a second display portion coupled to the second housing part, and a third display portion, extending from the first display portion to the second display portion, configured to be bent by the hinge assembly in a folded state of the foldable electronic device,
wherein the first housing part further includes a first bracket, supporting the first display portion of the flexible display, coupled to the first heat-conductive plate,
wherein the second housing part further includes a second bracket, supporting the second display portion of the flexible display, coupled to the second heat-conductive plate, and
wherein the second heat-conductive plate is movable with respect to the second bracket and disposed under the third display portion together with the first heat-conductive plate in the unfolded state of the foldable electronic device.

15. The foldable electronic device of claim 1,
wherein the first and second heat-conductive plates have elasticity.
